# EUROPEAN PATENT APPLICATION

(11) **EP 4 770 367 A1**
(43) Date of publication of application: **01.07.2026**
(21) Application number: 25215809.2
(22) Date of filing: 14.11.2025
(51) Int. Cl.: H10K 59/122, H10K 59/38, H10K 59/35

(54) **LIGHT EMITTING DISPLAY APPARATUS**

(30) Priority: 26.12.2024 KR 20240197743
(71) Applicant: LG Display Co., Ltd., Seoul, 07336 (KR)
(72) Inventor: AHN, JiYoung, 10845 GYEONGGI-DO (KR)
(74) Representative: Ter Meer Steinmeister & Partner

(57) **Abstract**

A light emitting display apparatus may include a substrate (111) including a plurality of subpixels (SP1, SP2, SP3, SP4) arranged in a first direction, each including an emission area (EA) and a non-emission area (NEA); at least one thin film transistor disposed in the non-emission area on the substrate; at least one protective layer disposed on the at least one thin film transistor; and at least one color filter (CF) disposed on the at least one protective layer, in at least some of the plurality of subpixels. Each of the plurality of subpixels may include a pixel electrode (AE), an emission layer (EL), a common electrode (CE), and a bank portion (BA) defining an opening area of the pixel electrode, and for at least one subpixel among the plurality of subpixels, the bank portion may further include a non-opening bank portion (NBA) extending toward a center portion of the pixel electrode in the first direction or a second direction intersecting the first direction to define a non-opening area of the pixel electrode.

## Description

This application claims priority to Korean Patent Application No. 10-2024-0197743 filed in Republic of Korea on December 26, 2024.

### BACKGROUND

### Technical Field

The disclosure relates to a light emitting display apparatus.

### Description of the Related Art

With the advancement of the information age, the demand for a display apparatus for displaying an image has increased in various forms. Therefore, various types of display apparatuses such as a liquid crystal display (LCD) apparatus, an organic light emitting display (OLED) apparatus, a micro light emitting diode (LED) display apparatus and a quantum dot display (QD) apparatus have been recently used.

Among display apparatuses, the organic light emitting display apparatus is a self-luminance type. In the organic light emitting display apparatus, hole and electron are injected into an emission layer from an anode electrode for hole injection and a cathode electrode for electron injection, and the injected hole and electron are bonded to each other. Herein, the bonded hole and electron exciton fall from the excited state to the ground state, the organic light emitting display apparatus may emit light and display an image.

Such the organic light emitting display apparatus has primarily employed a polarizer on a display surface of a panel to reduce external light reflection. However, when the organic light emitting display apparatus uses a polarizer, transmittance decreases, thereby reducing panel efficiency and increasing power consumption.

### SUMMARY

It is an object provide a light emitting display apparatus capable of reducing reflectance, improving light efficiency, and enhancing reflected color and visual perception without using a polarizer.

It is another object to provide a light emitting display apparatus capable of reducing reflectance, improving light efficiency, and enhancing reflected color and visual perception while minimizing or reducing additional mask processes.

Additional advantages and features of the disclosure will be set forth in part in the description which follows and in part will become apparent to those having ordinary skill in the art upon examination of the following or may be learned from practice of the disclosure. The objectives and other advantages of the disclosure may be realized and attained by the structure particularly pointed out in the written description and claims hereof as well as the appended drawings.

The object is solved by the features of the independent claims. Preferred embodiments are given in the dependent claims.

A light emitting display apparatus according to one or more embodiments may include a substrate including a plurality of subpixels arranged in a first direction, each of the plurality of subpixels including an emission area and a non-emission area; at least one thin film transistor disposed in the non-emission area on the substrate; at least one protective layer disposed on the at least one thin film transistor; and at least one color filter disposed on the at least one protective layer, in at least some of the plurality of subpixels, wherein each of the plurality of subpixels may include a pixel electrode, an emission layer, a common electrode, and a bank portion defining an opening area of the pixel electrode, and for at least one subpixel among the plurality of subpixels, the bank portion may further include a non-opening bank portion extending toward a center portion of the pixel electrode in the first direction or a second direction intersecting the first direction to define a non-opening area of the pixel electrode.

By providing a non-opening bank portions which extend from the bank portions of the non-emission areas NEA toward center portions of the pixel electrodes of the corresponding subpixels aperture ratios of the emission areas are optimized and/or additional mask processes are minimized or reduced. Accordingly, the light emitting display apparatus may reduce the reflectance increased by not using a polarizer, and may improve light efficiency.

In one or more embodiments, the bank portion may include at least one of a light absorbing material and a black material.

In one or more embodiments, the opening area of the pixel electrode may overlap the emission area.

In one or more embodiments, the non-opening area of the pixel electrode may overlap the non-emission area.

In one or more embodiments, the non-opening bank portion may be disposed between the pixel electrode and the emission layer.

In one or more embodiments, the non-opening bank portion may be disposed over the pixel electrodes of the plurality of subpixels in parallel in the first direction.

In one or more embodiments, for at least one other subpixel among the plurality of subpixels, the bank portion may be devoid of the non-opening bank portion.

In one or more embodiments, the non-opening bank portion of the at least one subpixel may extend toward the center portion of the pixel electrode in the first direction or the second direction more than the bank portion of the at least one other subpixel.

In one or more embodiments, the non-opening bank portion may include a first sub non-opening bank portion and a second sub non-opening bank portion spaced apart from each other in the second direction with the opening area of the pixel electrode interposed therebetween.

In one or more embodiments, the non-opening bank portion of the bank portion of the at least one subpixel may be a first non-opening bank portion.

In one or more embodiments, the bank portion of at least one other subpixel among the plurality of subpixels may include a second non-opening bank portion different from the first non-opening bank portion.

In one or more embodiments, the first non-opening bank portion may extend toward the center portion of the pixel electrode in the second direction more than the second non-opening bank portion.

In one or more embodiments, the at least one color filter may be disposed to overlap with the non-opening area of the pixel electrode.

In one or more embodiments, the plurality of subpixels may include a first subpixel, a second subpixel, a third subpixel, and a fourth subpixel.

In one or more embodiments, the non-opening bank portion may extend toward the center portion of the pixel electrode of each of the first to fourth subpixels in the second direction.

In one or more embodiments, the second subpixel may be a white subpixel in which the at least one color filter is not disposed.

In one or more embodiments, color filters of the first, third, and fourth subpixels, among the at least one color filter, may be disposed to overlap with the non-opening bank portion.

In one or more embodiments, at least one of the first subpixel and the third subpixel adjacent to the second subpixel may be disposed such that at least a portion of the color filter of the at least one of the first subpixel and the third subpixel extends in the first direction to overlap with the second subpixel.

In one or more embodiments, the color filter overlapping the second subpixel may be disposed to overlap with either the non-opening bank portion of the second subpixel or the opening area of the second subpixel.

In one or more embodiments, the first subpixel may be a red subpixel, the third subpixel may be a blue subpixel, and the fourth subpixel may be a green subpixel.

In one or more embodiments, the third subpixel may be between the second subpixel and the fourth subpixel in the first direction.

In one or more embodiments, at least a portion of the color filter of the third subpixel may extend in the first direction to overlap with the second subpixel and the fourth subpixel.

In one or more embodiments, an extended portion of the color filter of the third subpixel may be disposed to overlap with the non-opening bank portion of the fourth subpixel.

In one or more embodiments, the extended portion of the color filter of the third subpixel my overlap with or may not overlap with the color filter of the fourth subpixel.

In one or more embodiments, the common electrode may further include a low-reflection metal layer.

In one or more embodiments, the pixel electrode may further include a low-reflection metal layer.

In one or more embodiments, the light emitting display apparatus may further comprise a transmittance control film disposed on a rear surface of the substrate.

In one or more embodiments, the transmittance control film may include at least one of a transparent film and a light absorbing film.

According to one or more embodiments of the disclosure, a light emitting display apparatus capable of reducing reflectance, improving light efficiency, and enhancing reflected color and visual perception without using a polarizer may be provided.

According to one or more embodiments, a light emitting display apparatus capable of reducing reflectance, improving light efficiency, and enhancing reflected color and visual perception while minimizing or reducing additional mask processes may be provided.

The light emitting display apparatus according to one or more embodiments may simplify the manufacturing process by eliminating the need for a polarizer while minimizing or reducing additional mask processes. As a result, it is possible to reduce greenhouse gas emissions generated during manufacturing and achieve Environmental, Social, and Governance (ESG) benefits.

The effects of the disclosure are not limited to the aforesaid, but other effects not described herein will be clearly understood by those skilled in the art from the following descriptions.

The details of the present disclosure described in technical problem, technical solution, and advantageous effects do not specify essential features of claims, and thus, the scope of claims is not limited by the details described in detailed description of the disclosure.

### BRIEF DESCRIPTION OF THE DRAWINGS

The accompanying drawings, which are included to provide a further understanding of the disclosure, are incorporated in and constitute a part of this disclosure, illustrate aspects and embodiments of the disclosure, and together with the description serve to explain the principles and examples of the disclosure.
FIG. 1 illustrates a light emitting display apparatus according to an embodiment of the disclosure.
FIG. 2 is a circuit diagram illustrating a subpixel of a light emitting display apparatus according to an embodiment of the disclosure.
FIG. 3 illustrates a pixel structure of a light emitting display apparatus of an embodiment of the disclosure.
FIG. 4 illustrates a bank portion and a color filter of a pixel of an embodiment of the disclosure.
FIG. 5 is a cross-sectional view taken along line I-I' of FIG. 4 of an embodiment of the disclosure.
FIG. 6 illustrates a bank portion and a color filter of a pixel of one embodiment of the disclosure.
FIG. 7 is a cross-sectional view taken along line II-II' of FIG. 6 of one embodiment of the disclosure.
FIG. 8 illustrates a bank portion and a color filter of a pixel of another embodiment of the disclosure.
FIG. 9 is a cross-sectional view taken along line III-III' of FIG. 8 of another embodiment of the disclosure.
FIG. 10 illustrates a bank portion and a color filter of a pixel of another embodiment of the disclosure.
FIG. 11 is a cross-sectional view taken along line IV-IV' of FIG. 10 of another embodiment of the disclosure.
FIG. 12 illustrates a bank portion and a color filter of a pixel of another embodiment of the disclosure.
FIG. 13 is a cross-sectional view taken along line V-V' of FIG. 12 of another embodiment of the disclosure.
FIG. 14 illustrates a bank portion and a color filter of a pixel of another embodiment of the disclosure.
FIG. 15 is a cross-sectional view taken along line VI-VI' of FIG. 14 of another embodiment of the disclosure.
FIG. 16 illustrates a bank portion and a color filter of a pixel of another embodiment of the disclosure.
FIG. 17 cross-sectional view taken along line VII-VII' of FIG. 16 of another embodiment of the disclosure.
FIG. 18 illustrates a bank portion and a color filter of a pixel of another embodiment of the disclosure.
FIG. 19 illustrates a bank portion and a color filter of a pixel of another embodiment of the disclosure.
FIG. 20 illustrates a bank portion and a color filter of a pixel of another embodiment of the disclosure.
FIG. 21 cross-sectional view taken along line VIII-VIII' of FIG. 20 of another embodiment of the disclosure.
FIG. 22 illustrates a bank portion and a color filter of a pixel of another embodiment of the disclosure.
FIG. 23 is a cross-sectional view taken along line IX-IX' of FIG. 22 of another embodiment of the disclosure.
Throughout the drawings and the detailed description, unless otherwise described, the same drawing reference numerals should be understood to refer to the same elements, features, and structures. The sizes, lengths, and thicknesses of layers, regions and elements, and depiction of thereof may be exaggerated for clarity, illustration, and/or convenience.

### DETAILED DESCRIPTION OF THE DISCLOSURE

Advantages and features of the disclosure, and implementation methods thereof, are clarified through the embodiments described with reference to the accompanying drawings. The disclosure may, however, be embodied in different forms and should not be construed as limited to the embodiments set forth herein. Rather, these embodiments are examples and are provided so that this disclosure may be thorough and complete, to assist those skilled in the art to understand the inventive concepts without limiting the protected scope of the disclosure.

Shapes (e.g., sizes, lengths, widths, heights, thicknesses, locations, radii, diameters, and areas), sizes, ratios, angles, numbers, and the like disclosed herein, including those illustrated in the drawings are merely examples, and thus, the present disclosure is not limited to the illustrated details. Any implementation described herein as an "example" is not necessarily to be construed as preferred or advantageous over other implementations. It is, however, noted that the relative dimensions of the components illustrated in the drawings are part of the disclosure.

When the term "comprise," "have," "include," "contain," "constitute," "made of," "formed of," or the like is used with respect to one or more elements, one or more other elements may be added unless a term such as "only" or the like is used. The terms used in the present disclosure are merely used in order to describe embodiments, and are not intended to limit the scope of the present disclosure. The terms of a singular form may include plural forms unless the context clearly indicates otherwise.

In construing an element, the element is construed as including an error region although there is no explicit description thereof.

In describing a positional relationship, for example, when the positional order is described as "on," "above," "below," "beneath", and "next," the case of no contact therebetween may be included, unless "just" or "direct" is used.

If it is mentioned that a first element is positioned "on" a second element, it does not mean that the first element is essentially positioned above the second element in the figure. The upper part and the lower part of an object concerned may be changed depending on the orientation of the object. Consequently, the case in which a first element is positioned "on" a second element includes the case in which the first element is positioned "below" the second element as well as the case in which the first element is positioned "above" the second element in the figure or in an actual configuration.

In describing a temporal relationship, for example, when the temporal order is described as "after," "subsequent," "next," and "before," a case which is not continuous may be included, unless "just" or "direct" is used.

It will be understood that, although the terms "first," "second," etc. may be used herein to describe various elements, these elements should not be limited by these terms. These terms are only used to distinguish one element from another. For example, a first element could be termed a second element, and, similarly, a second element could be termed a first element.

In describing elements of the disclosure, the terms "first," "second," "A," "B," "(a)," "(b)," or the like may be used. These terms are intended to identify the corresponding element(s) from the other element(s), and these are not used to define the essence, basis, order, or number of the elements.

For the expression that an element is "connected," "coupled," "attached," "adhered," or the like to another element, the element may not only be directly connected, coupled, attached, adhered, or the like to another element, but also be indirectly connected, coupled, attached, adhered, or the like to another element with one or more intervening elements disposed or interposed between the elements, unless otherwise specified.

For the expression that an element is "contacts," "overlaps," or the like with another element, the element may not only directly contact, overlap, or the like with another element, but also indirectly contact, overlap, or the like with another element with one or more intervening elements disposed or interposed between the elements, unless otherwise specified.

The term "at least one" should be understood as including any and all combinations of one or more of the associated listed items. For example, "at least one among a first element, a second element and a third element" may include all combinations of two or more elements selected from the first, second and third elements as well as each element of the first, second and third elements.

Features of various embodiments may be partially or entirety coupled to or combined with each other, may be technically associated with each other, and may be variously inter-operated, linked or driven together. The embodiments of the disclosure may be implemented or carried out independently of each other, or may be implemented or carried out together in a co-dependent or related relationship. In one or more aspects, the components of each apparatus according to various embodiments of the disclosure are operatively coupled and configured.

In the following description, various embodiments of the disclosure are described in detail with reference to the accompanying drawings. With respect to reference numerals to elements of each of the drawings, the same elements may be illustrated in other drawings, and like reference numerals may refer to like elements unless stated otherwise. The same or similar elements may be denoted by the same reference numerals even though they are depicted in different drawings. In addition, for convenience of description, a scale, dimension, size, and thickness of each of the elements illustrated in the accompanying drawings may be different from an actual scale, dimension, size, and thickness, and thus, embodiments of the present disclosure are not limited to a scale, dimension, size, and thickness illustrated in the drawings.

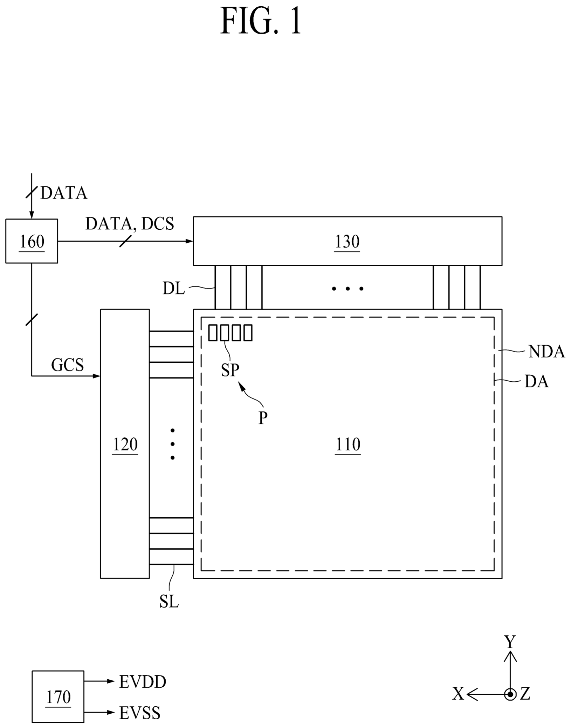

FIG. 1 illustrates a light emitting display apparatus according to an embodiment of the disclosure.

Hereinafter, an X-axis represents a direction parallel to a scan line (or a gate line), a Y-axis represents a direction parallel to a data line, and a Z-axis represents a height direction of the light emitting display apparatus. The X-axis may intersect with the Y-axis, and the Z-axis may be perpendicular to the X-axis and the Y-axis. For example, the X-axis, the Y-axis, and the Z-axis may be perpendicular to each other.

A light emitting display apparatus according to an embodiment of the disclosure is implemented as an organic light emitting display apparatus, but may also be implemented as a liquid crystal display apparatus, a quantum dot lighting emitting diode display apparatus, or an electrophoretic display apparatus.

Referring to FIG. 1, the light emitting display apparatus according to an embodiment of the disclosure may include a display panel 110, a scan driver 120 (or a gate driver) embedded in the display panel 110, a data driver 130 connected to the display panel 110, a timing controller 160 controlling the scan driver 120 and the data driver 130, and a power circuit 170.

The display panel 110 includes a display area DA and a non-display area NDA surrounding the display area DA. The display panel 110 includes pixels P provided in the display area DA to display an image. Each of the pixels P may include a plurality of subpixels SP. The structure of the subpixel SP may be variously changed according to the type of the light emitting display apparatus. For example, the subpixels SP may be formed in a top emission type, a bottom emission type, or a dual emission type according to the structure. The subpixels SP indicate a unit capable of forming a color filter of a specific type or capable of emitting a color of itself without forming a color filter. The subpixels SP may have one or more other light-emitting areas according to light-emitting characteristics. For example, the plurality of subpixels SP may be arranged in a stripe type or a quad type, but embodiments of the disclosure are not limited thereto. The color type, arrangement type, arrangement order, and the like of the subpixels SP may be configured in various forms according to the light-emitting characteristics, lifespan of the apparatus, spec of the apparatus, and the like.

The display panel 110 may include data lines DL and scan lines SL (or gate lines) connected to the subpixels SP. The data lines DL may be arranged to cross the scan lines SL. Each of the subpixels SP of the display panel 110 may be connected to any one of the data lines DL and any one of the scan lines SL. The data lines DL may supply a data voltage supplied from the data driver 130 to each of the subpixels SP. The scan lines SL may supply a scan signal supplied from the scan driver 120 to each of the subpixels SP

Each of the subpixels SP is turned-on by the scan signal. When the data voltage of the data line DL is supplied to a gate electrode of a driving transistor, a light emitting element may emit light according to a drain-to-source current of the driving transistor. The scan driver 120 may receive a scan control signal GCS from the timing controller 160. The scan driver 120 may supply the scan signals or emission control signal to the scan lines SL by using the scan control signal GCS.

The scan driver 120 may be configured in a gate driver in panel (GIP) manner in the non-display area NDA outside one side or both sides of the display area DA. Alternatively, the scan driver 120 may be manufactured as a driving chip, mounted on a flexible film, and attached to the non-display area NDA outside one side or both sides of the display area DA in a tape automated bonding (TAB) manner.

The data driver 130 may receive digital video data DATA and a data control signal DCS from the timing controller 160. The data driver 130 converts the digital video data DATA into analog positive/negative data voltages by using the data control signal DCS and supplies the analog positive/negative data voltages to the data lines DL.

The timing controller 160 receives digital video data DATA and timing signals from a host system. The timing signals may include a vertical synchronization signal, a horizontal synchronization signal, a data enable signal, a dot clock, and the like. The vertical synchronization signal is a signal defining one frame period. The horizontal synchronization signal is a signal defining one horizontal period required for supplying the data voltages to the pixels of one horizontal line of the display panel 110. The data enable signal defines a period in which valid data is input. The dot clock is a signal repeated at a predetermined short period.

The timing controller 160 may generate the data control signal DCS for controlling an operation timing of the data driver 130 and the scan control signal GCS for controlling an operation timing of the scan driver 120 based on the timing signals. The timing controller 160 may output the scan control signal GCS to the scan driver 120 to control the scan driver 120 and output the digital video data DATA and data control signal DCS to the data driver 130 to control the data driver 130.

The power circuit 170 may generate and supply a plurality of driving voltages required for an operation of all circuit configurations of the light emitting display apparatus by using an input voltage. The power circuit 170 may generate a first power source voltage EVDD (or pixel power voltage), a second power supply voltage EVSS (or common power voltage) and an initialization voltage Vref (or reference voltage) and supply the generated voltages to the display panel 110. The power circuit 170 may generate and supply various driving voltages required for operations of the scan driver 120, the data driver 130, and the timing controller 160.

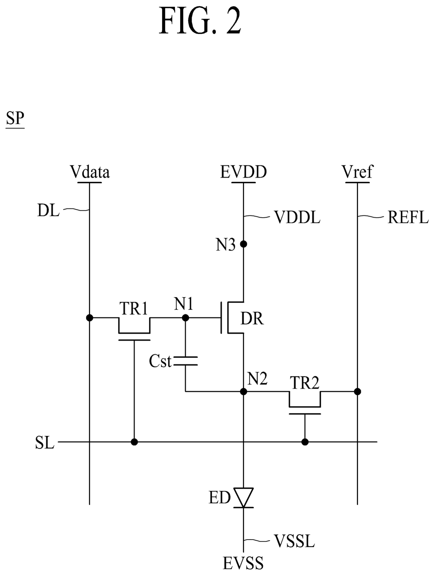

FIG. 2 is a circuit diagram illustrating a subpixel of a light emitting display apparatus according to an embodiment of the disclosure.

Referring to FIG. 2, each of pixels P includes the plurality of subpixels SP constituting a unit pixel. In each of the plurality of subpixels SP, there are a pixel circuit having 3T(Transistor)1C(Capacitor) including the driving transistor DR, the first switching transistor TR1, the second switching transistor TR2 and the storage capacitor Cst, and the light emitting device ED, but not limited thereto. Each subpixel SP may further include a compensation circuit. In this case, the subpixel SP may have various structures such as 3T2C, 4T1C, 4T2C, 5T1C, 5T2C, 6T1C, 6T2C, 7T1C, and 7T2C.

At least one thin film transistor DR, TR1 and TR2 of each subpixel SP may include a gate electrode, a source electrode, and a drain electrode. Since the source electrode and the drain electrode may be changed according to a voltage and a current direction applied to the gate electrode without being fixed, any one of the source electrode and the drain electrode may be represented as a first electrode, and the other may be represented as a second electrode. The at least one transistor DR, TR1, and TR2 may use at least one of polysilicon semiconductor, amorphous silicon semiconductor, and oxide semiconductor. The transistors DR, TR1, and TR2 may be P-type or N-type, or P-type and N-type may be interchangeably used.

The driving transistor DR corresponds to a transistor for driving the light emitting device ED, and the driving transistor DR includes the first node N1 to which the data voltage Vdata is applied, the second node N2 connected to a pixel electrode (first electrode or anode electrode) of the light emitting device ED, and the third node N3 connected to the first power line VDDL (or pixel power line) and supplied with the first power voltage EVDD (or pixel power voltage). For example, the driving transistor DR may generate a data current from the first power voltage EVDD supplied from the first power line VDDL and may supply the data current to the first electrode of the light emitting device ED.

The first switching transistor TR1 may serve to supply the data voltage Vdata supplied from the data line DL to the first node N1 of the driving transistor DR. The second switching transistor TR2 may serve to supply the reference voltage Vref supplied from the reference line REFL to the second node N2 of the driving transistor DR or may output a voltage of the second node N2 of the driving transistor DR. The storage capacitor Cst may be connected between the first node N1 and the second node N2 of the driving transistor DR. The storage capacitor Cst may serve to maintain the data voltage Vdata supplied to the driving transistor DR for one frame, but embodiments of the present disclosure are not limited thereto.

The light emitting device ED may include the pixel electrode (first electrode or anode electrode) connected to the second node N2 of the driving transistor DR, the common electrode (second electrode or cathode electrode) connected to the second power line VSSL. The light emitting device ED may emit light in response to a driving current generated by the driving transistor DR through an emission layer (or organic emission layer) between the first electrode and the second electrode. The pixel electrode of the light emitting device ED may be an independent electrode for each light emitting device, and the common electrode and the emission layer of the light-emitting device ED may be a common layer shared by the entire light emitting devices, but embodiments of the present disclosure are not limited thereto.

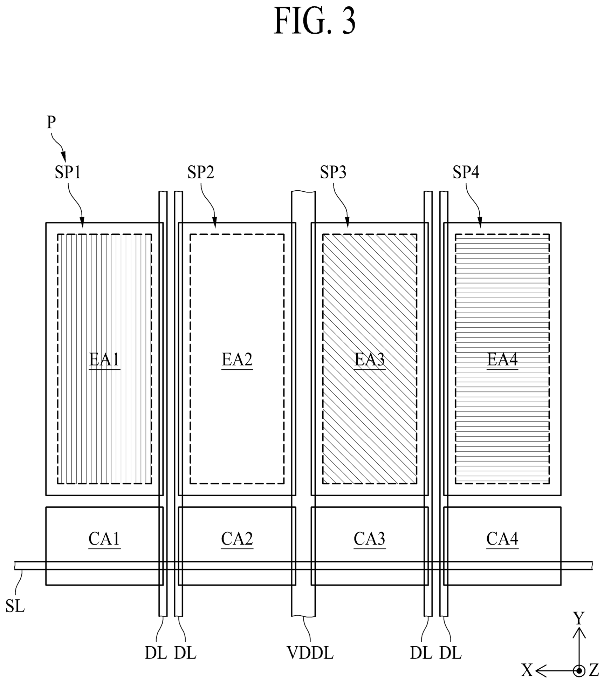

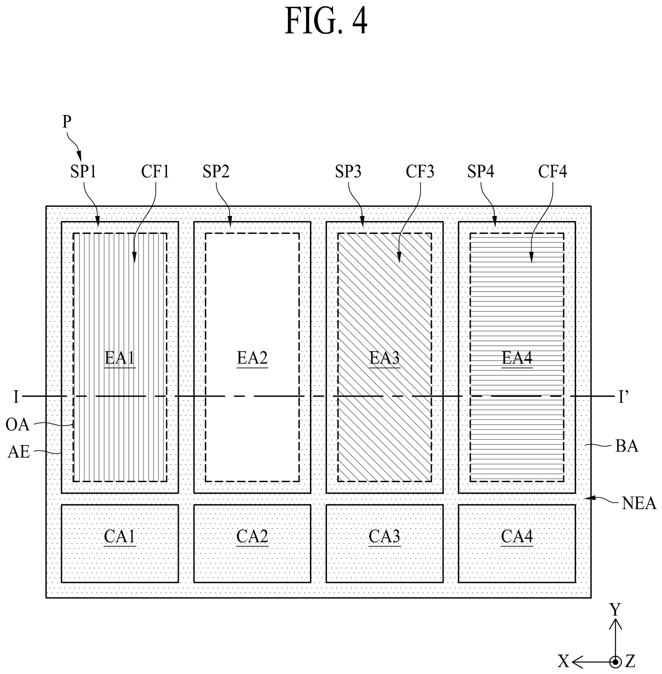

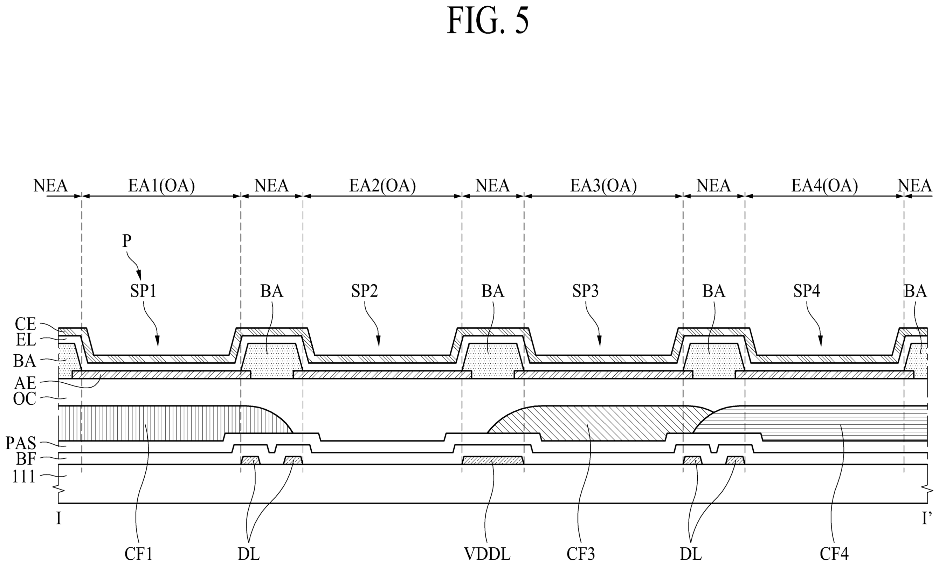

FIG. 3 illustrates a pixel structure of a light emitting display apparatus of an embodiment of the disclosure. FIG. 4 illustrates a bank portion and a color filter of a pixel of an embodiment of the disclosure. FIG. 5 is a cross-sectional view taken along line I-I' of FIG. 4 of an embodiment of the disclosure.

Referring to FIGS. 3 to 5, the light emitting display apparatus according to an embodiment of the disclosure may include the pixel P, the data line DL, the scan line SL (or gate line), the first power line VDDL, the pixel circuits CA1, CA2, CA3 and CA4, the at least one color filter CF1, CF3 and CF4, and the bank portion BA.

The pixel P may include the plurality of subpixels SP1, SP2, SP3 and SP4. The plurality of subpixels SP1, SP2, SP3 and SP4 may include the first to fourth subpixels SP1, SP2, SP3 and SP4. The first to fourth subpixels SP1, SP2, SP3 and SP4 may be arranged in a first direction (or X-axis direction) or a second direction (or Y-axis direction). For example, the first to fourth subpixels SP1, SP2, SP3 and SP4 may be arranged adjacent to each other in the first direction (or X-axis direction). The first to fourth subpixels SP1, SP2, SP3 and SP4 may include emission areas EA1, EA2, EA3 and EA4 that emit light, and the non-emission area NEA.

The emission areas EA1, EA2, EA3 and EA4 may correspond to areas in the pixel P where light is emitted. The emission areas EA1, EA2, EA3 and EA4 may include first to fourth emission areas EA1, EA2, EA3 and EA4 that emit light of different colors. For example, the first to fourth emission areas EA1, EA2, EA3 and EA4 may overlap the opening areas OA of the pixel electrode AE (a first electrode or an anode electrode) defined by the bank portion BA.

The first to fourth emission areas EA1, EA2, EA3 and EA4 may overlap at least one color filter CF1, CF3 and CF4 corresponding to the first to fourth subpixels SP1, SP2, SP3 and SP4. For example, the first to fourth emission areas EA1, EA2, EA3 and EA4 may overlap the opening area OA of the pixel electrode AE and at least one color filter CF1, CF3 and CF4.

The first to fourth emission areas EA1, EA2, EA3 and EA4 may emit light of different colors through at least one color filter CF1, CF3 and CF4. For example, the at least one color filter CF1, CF3 and CF4 may emit light of different colors. For example, the at least one color filter CF1, CF3 and CF4 may be formed of an organic material that transmits or emits light of different colors. The at least one color filter CF1, CF3 and CF4 may include the first color filter CF1 that transmits/emits red light, the third color filter CF3 that transmits/emits blue light, and the fourth color filter CF4 that transmits/emits green light. For example, the first emission area EA1 of the first subpixel SP1 may emit red light through the first color filter CF1, the second emission area EA2 of the second subpixel SP2 may not be provided with a color filter and may emit white light, the third emission area EA3 of the third subpixel SP3 may emit blue light through the third color filter CF3, and the fourth emission area EA4 of the fourth subpixel SP4 may emit green light through the fourth color filter CF4, but embodiments of the present disclosure are not limited thereto.

The non-emission area NEA may include the data line DL, scan line SL (or gate line), the first power line VDDL, and the pixel circuits CA1, CA2, CA3 and CA4. The non-emission area NEA may overlap the bank portion BA. For example, the non-emission area NEA may be an area excluding the first to fourth emission areas EA1, EA2, EA3 and EA4 of the first to fourth subpixels SP1, SP2, SP3 and SP4.

The scan line SL extending in the first direction (or X-axis direction) may be disposed in the non-emission area NEA, and the data line DL and the first power line VDDL extending in the second direction (or Y-axis direction) intersecting the first direction may be disposed in the non-emission area NEA. Also, the second power line VSSL extending in the second direction may be disposed in the non-emission area NEA, but embodiments of the present disclosure are not limited thereto.

The pixel circuits CA1, CA2, CA3 and CA4 corresponding to each of the subpixels SP1, SP2, SP3 and SP4 may be disposed in the non-emission area NEA. For example, as shown in FIG. 2, each of the pixel circuits CA1, CA2, CA3 and CA4 may include the at least one thin film transistor DR, TR1 and TR2 and the storage capacitor Cst. The at least one thin film transistor DR, TR1 and TR2 may include the driving transistor DR, the first switching transistor TR1 and the second switching transistor TR2, but embodiments of the present disclosure are not limited thereto.

Referring to FIG. 5, the light emitting display apparatus according to an embodiment of the disclosure may include the substrate 111, the data line DL, the first power line VDDL, the buffer layer BF, the passivation layer PAS, the at least one color filter CF1, CF3 and CF4, the planarization layer OC, the pixel electrode AE, the organic emission layer EL, the common electrode CE, and the bank portion BA.

On the substrate 111, at least some of the at least one signal lines may be disposed. For example, on the substrate 111, the data line DL and the first power line VDDL may be disposed. Also, on the substrate 111, the reference line REFL and the second power line VSSL may be disposed, but embodiments of the present disclosure are not limited thereto. For example, at least one signal line disposed at the bottommost portion of the substrate 111 may be formed of the same material in the same layer as a light-shielding layer disposed in the pixel circuits CA1, CA2, CA3, and CA4. For example, the light-shielding layer may function to block external light incident on the active layer of the thin-film transistor. For example, the light-shielding layer may serve to block external light incident on an active layer of a thin film transistor. The light-shielding layer may be formed of a single layer or a multilayer of any one or more of molybdenum (Mo), aluminum (Al), chromium (Cr), gold (Au), titanium (Ti), nickel (Ni), neodymium (Nd), and copper (Cu), or an alloy thereof.

The buffer layer BF may be disposed on the substrate 111. The buffer layer BF may be configured to cover at least one signal line and a light-shielding layer disposed on the substrate 111. At least one protective layer and at least one thin film transistor may be disposed on the buffer layer BF. For example, the at least one protective layer may include the passivation layer PAS. The passivation layer PAS may be formed of a single layer or a multilayer that includes an inorganic insulating material such as silicon oxide (SiOX), silicon nitride (SiNX), or aluminum oxide (Al2O3).

The at least one color filter CF1, CF3 and CF4 may be disposed, preferably directly disposed, on the passivation layer PAS. The at least one color filter CF1, CF3 and CF4 may be disposed to correspond to the first subpixel SP1, the third subpixel SP3, and the fourth subpixel SP4 among the first to fourth subpixels SP1, SP2, SP3 and SP4. So, the at least one color filter CF1, CF3 and CF4 overlap with the first subpixel SP1, the third subpixel SP3, and the fourth subpixel SP4 respectively.

A color filter may not be disposed in the second subpixel SP2 among the first to fourth subpixels SP1, SP2, SP3, and SP4. For example, the first color filter CF1 that converts white light emitted from the organic emission layer EL into red may be disposed in the first emission area EA1 of the first subpixel SP1. The second emission area EA2 of the second subpixel SP2 may emit white light as it is without a color filter. The third color filter CF3 that converts white light emitted from the organic emission layer EL into blue may be disposed in the third emission area EA3 of the third subpixel SP3. The fourth color filter CF4 that converts white light emitted from the organic emission layer EL into green may be disposed in the fourth emission area EA4 of the fourth subpixel SP4.

The planarization layer OC (or an overcoat layer) may be disposed on the passivation layer PAS and at least one color filter CF1, CF3 and CF4. The planarization layer OC may planarize step differences caused by at least one signal line, at least one thin film transistor, and at least one color filter CF1, CF3 and CF4 disposed on the substrate 111, and may be formed of an organic insulating material. For example, the planarization layer OC may be formed of an organic material such as acryl resin, epoxy resin, phenolic resin, polyamide resin, or polyimide resin, but embodiments of the present disclosure are not limited thereto.

The pixel electrode AE (first electrode or anode electrode), the organic emission layer EL, the common electrode CE (second electrode or cathode electrode), and the bank portion BA that constitute the light emitting device ED may be disposed on the planarization layer OC.

The pixel electrode AE may be disposed on the planarization layer OC. The pixel electrode AE may be patterned and disposed for each subpixel SP1, SP2, SP3 and SP4 on the planarization layer OC. The pixel electrode AE may be formed of a transparent metal material or a semi-transmissive metal material. For example, the pixel electrode AE may be formed of a transparent conductive material TCO such as indium tin oxide (ITO) or indium zinc oxide (IZO) that may transmit light. The pixel electrode AE may be formed of a semi-transmissive conductive material such as magnesium (Mg), silver (Ag), or an alloy of magnesium (Mg) and silver (Ag). For example, the pixel electrode AE formed of the semi-transmissive metal material may improve light extraction efficiency by a micro cavity. The pixel electrode AE may be an anode electrode of the light emitting device ED. According to an embodiment of the present disclosure, the pixel electrode AE may further include a low-reflection metal layer. For example, the low-reflection metal layer may include a metal oxide or an alloy oxide. For example, the low-reflection metal layer may include copper oxide (CuOx), nickel oxide (NiOx), molybdenum oxide (MoOx), or tungsten oxide (WOx), but embodiments of the present disclosure are not limited thereto.

The bank portion BA may be disposed on the pixel electrode AE and the planarization layer OC. The bank portion BA may be disposed on the planarization layer OC to cover a portion of the edge of the pixel electrode AE. In other words, the bank portion BA may have a main body portion (which may also be referred to as "a first sub-portion") extending around the edges of the pixel electrode AE. The bank portion BA may be configured to define the opening area OA of the pixel electrode AE. The opening area OA of the pixel electrode AE may correspond to the emission areas EA1, EA2, EA3 and EA4 of each subpixel SP1, SP2, SP3 and SP4. For example, the opening area OA of the pixel electrode AE exposed by the bank portion BA may be configured as the emission areas EA1, EA2, EA3 and EA4 that directly contact the emission layer EL and emit light.

The bank portion BA may be disposed in the non-emission area NEA of each subpixel SP1, SP2, SP3 and SP4. The bank portion BA may overlap the pixel circuits CA1, CA2, CA3 and CA4, and at least one signal line. For example, the bank portion BA may be formed of an organic layer such as acryl resin, epoxy resin, phenolic resin, polyamide resin, or polyimide resin. According to an embodiment of the present disclosure, the bank portion BA may be a black bank that includes at least one of a light-absorbing material or a black material. For example, the bank portion BA may include an insulating light-absorbing material such as black resin or graphite.

The organic emission layer EL may be disposed on the pixel electrode AE and the bank portion BA. The organic emission layer EL may include a hole transporting layer, an emission material layer, and an electron transporting layer. For example, when a voltage is applied to the pixel electrode AE and the common electrode CE, holes and electrons may move to the organic emission layer EL through the hole transporting layer and the electron transporting layer, respectively, and may be combined with each other in the organic emission layer EL to emit light. The organic emission layer EL may be a common layer commonly formed over the plurality of subpixels SP1, SP2, SP3 and SP4. For example, the organic emission layer EL may be a white emission layer that emits white light.

The common electrode CE may be disposed on the organic emission layer EL. The common electrode CE may be a common layer commonly formed over the plurality of subpixels SP1, SP2, SP3 and SP4. The common electrode CE may be disposed on the pixel electrode AE and the organic emission layer EL, which are in contact with each other, to constitute the light emitting device ED. For example, the common electrode CE may be formed of a metal material having high reflectance, such as a stacked structure (Ti/Al/Ti) of aluminum and titanium, a stacked structure (ITO/Al/ITO) of aluminum and ITO, Ag alloy, a stacked structure (ITO/Ag alloy/ITO) of Ag alloy and ITO, MoTi alloy, and a stacked structure (ITO/MoTi alloy/ITO) of MoTi alloy and ITO. The Ag alloy may be an alloy of silver (Ag), palladium (Pd), copper (Cu) and the like. The MoTi alloy may be an alloy of molybdenum (Mo) and titanium (Ti). The common electrode CE may be a cathode electrode of the light emitting device ED. According to an embodiment of the present disclosure, the common electrode CE may further include a low-reflection metal layer. For example, the low-reflection metal layer may include a metal oxide or an alloy oxide. For instance, the low-reflection metal layer may include copper oxide (CuOx), nickel oxide (NiOx), molybdenum oxide (MoOx), or tungsten oxide (WOx), but embodiments of the present disclosure are not limited thereto.

According to an embodiment of the disclosure, a transmittance control film may be further included on a rear surface of the substrate 111. For example, the transmittance control film may include at least one of a transparent film or an absorptive film, but embodiments of the disclosure are not limited thereto.

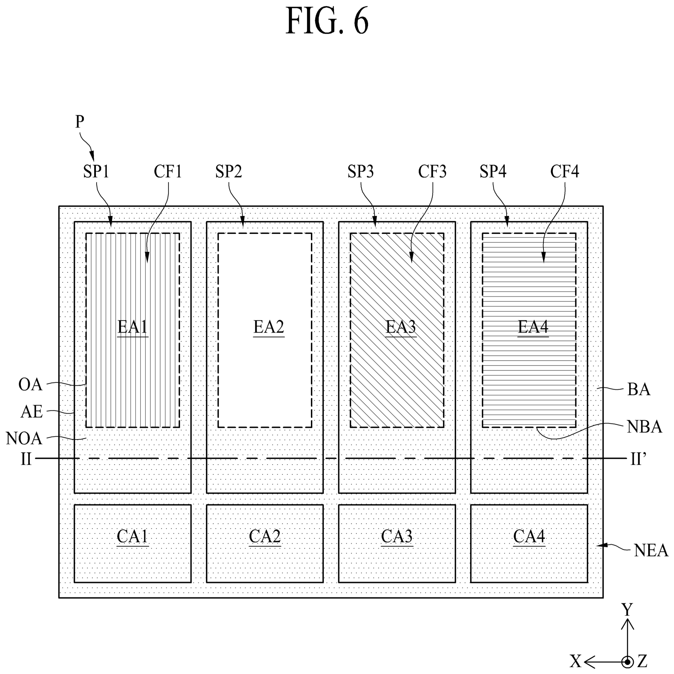

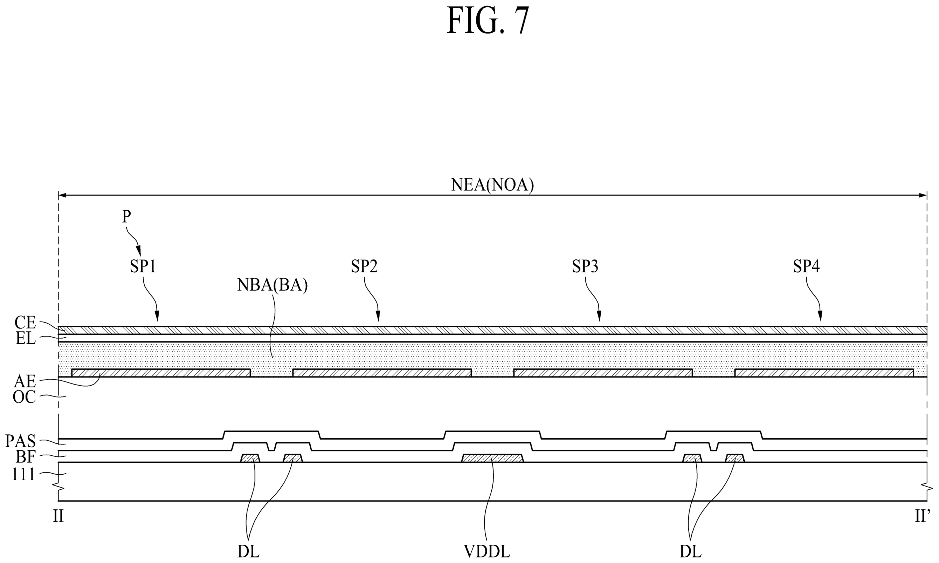

FIG. 6 illustrates a bank portion and a color filter of a pixel according to one embodiment of the present disclosure. FIG. 7 is a cross-sectional view taken along line II-II' of FIG. 6 according to one embodiment of the present disclosure. FIGS. 6 and 7 illustrate embodiments of the disclosure in which a configuration of the bank portion and the color filter is modified in the light emitting display apparatus described with reference to FIGS. 1 to 5. In the following description referring to FIGS. 6 and 7, the same reference numerals will be used for the same components, except for the modified configurations, and their redundant descriptions will be omitted or briefly described.

Referring to FIGS. 6 and 7, the light emitting display apparatus according to one embodiment of the disclosure may be configured such that the bank portion BA of the at least one of the subpixels SP1, SP2, SP3 and SP4 extends toward a central portion of the pixel electrode AE in a second direction (or a Y-axis direction) intersecting a first direction (or an X-axis direction) to define the non-opening area NOA of the pixel electrode AE. In other words, for the at least one of the subpixels SP1, SP2, SP3 and SP4, the bank portion BA may include a main body portion (which may also be referred to as "a first sub-portion") and a non-opening bank portion NBA (which may also be referred to as "a second sub-portion"). The main body portion extends around edges of the pixel electrode AE, and the non-opening bank portion NBA extends toward the center portion of the pixel electrode AE from the main body portion in the second direction. The main body portion and the non-opening bank portion NBA of the bank portion BA collectively define an opening area OA and a non-opening area NOA of the pixel electrode. For example, the opening area OA of the pixel electrode AE may overlap the emission areas EA1, EA2, EA3 and EA4 of each of the subpixels SP1, SP2, SP3 and SP4, and the non-opening area NOA of the pixel electrode AE may overlap the non-emission areas NEA of each of the subpixels SP1, SP2, SP3 and SP4.

The non-opening bank portion NBA of the bank portion BA of at least one of the subpixels SP1, SP2, SP3 and SP4 may be disposed in the non-opening area NOA of the pixel electrode AE. For example, the non-opening bank portion NBA may be disposed between the pixel electrode AE and the organic emission layer EL.

For example, a plurality of or all of the subpixels SP1, SP2, SP3 and SP4 may include the non-opening bank portion NBA. The non-opening bank portion NBA may be disposed over the respective pixel electrodes AE of the plurality of subpixels SP1, SP2, SP3 and SP4 in parallel in the first direction (or X-axis direction). For example, the non-opening bank portion NBA may be configured to extend from a lower end edge of the pixel electrode AE in the second direction to a center portion of the pixel electrode AE. The non-opening bank portion NBA of the plurality of subpixels SP1, SP2, SP3 and SP4 may have regions that overlap with the pixel electrodes AE of the plurality of subpixels SP1, SP2, SP3 and SP4, which may be different from each other. For example, the non-opening bank portion NBA of the second subpixel SP2 may be configured to have a region that overlaps with the pixel electrode AE to a greater extent than the non-opening bank portions NBA of the other subpixels SP1, SP3 and SP4, but embodiments of the disclosure are not limited thereto. For example, the non-opening bank portion NBA may cover a portion of the pixel electrode AE, thereby reducing the aperture ratio of the light emitting portion. Also, the non-opening bank portion NBA may absorb a portion of internal light that is reflected back from the common electrode CE through the pixel electrode AE, thereby reducing the cell reflectance of the light emitting portion.

The at least one color filter CF1, CF3 and CF4 may be disposed not to overlap the non-opening area NOA of the pixel electrode AE. For example, the at least one color filter CF1, CF3 and CF4 may not be disposed below the non-opening bank portion NBA. For example, the non-opening bank portion NBA may not overlap the at least one color filter CF1, CF3 and CF4. For example, the non-opening bank portion NBA may be disposed between the emission areas EA1, EA2, EA3 and EA4 of the plurality of subpixels SP1, SP2, SP3 and SP4 and the pixel circuits CA1, CA2, CA3 and CA4 of the plurality of subpixels SP1, SP2, SP3 and SP4.

According to one embodiment of the disclosure, the non-opening bank portions NBA of the plurality of subpixels SP1, SP2, SP3 and SP4 may be configured to extend from the bank portions BA of the non-emission areas NEA toward center portions of the pixel electrodes AE of the corresponding subpixels SP1, SP2, SP3 and SP4 to define the non-opening areas NOA of the pixel electrodes AE, thereby optimizing the aperture ratios of the emission areas EA1, EA2, EA3 and EA4 while minimizing or reducing additional mask processes. Accordingly, the light emitting display apparatus according to one embodiment of the disclosure may reduce the reflectance increased by not using a polarizer, and may improve light efficiency.

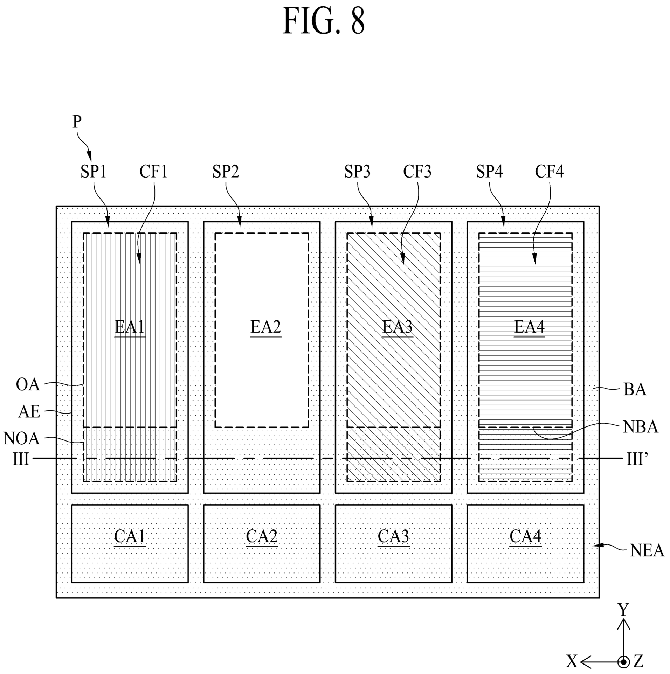

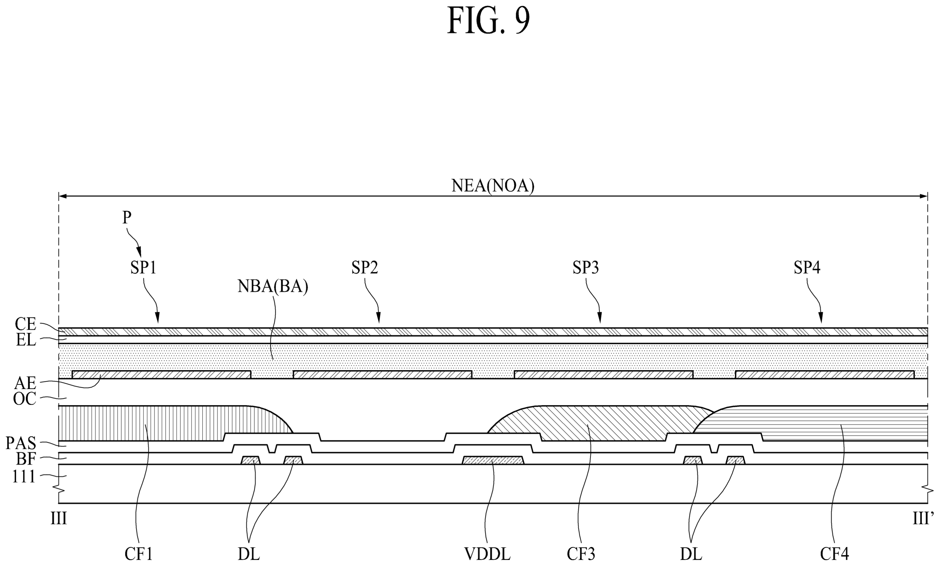

FIG. 8 illustrates a bank portion and a color filter of a pixel according to another embodiment of the disclosure. FIG. 9 is a cross-sectional view taken along line III-III' of FIG. 8 according to another embodiment of the disclosure. FIGS. 8 and 9 illustrate embodiments of the disclosure in which a configuration of the bank portion and the color filter is modified in the light emitting display apparatus described with reference to FIGS. 1 to 8. In the following description referring to FIGS. 8 and 9, the same reference numerals will be used for the same components, except for the modified configurations, and their redundant descriptions will be omitted or briefly described.

Referring to FIGS. 8 and 9, the light emitting display apparatus according to another embodiment of the present disclosure may be configured such that the bank portion BA of the at least one of the subpixels SP1, SP2, SP3 and SP4 extends toward a central portion of the pixel electrode AE in a second direction (or a Y-axis direction) intersecting a first direction (or an X-axis direction) to define the non-opening area NOA of the pixel electrode AE.

The non-opening bank portion NBA of the bank portion BA of at least one of the subpixels SP1, SP2, SP3 and SP4 may be disposed in the non-opening area NOA of the pixel electrode AE. For example, the non-opening bank portion NBA may be disposed between the pixel electrode AE and the organic emission layer EL.

For example, a plurality of or all of the subpixels SP1, SP2, SP3 and SP4 may include the non-opening bank portion NBA. The non-opening bank portion NBA may be disposed over the respective pixel electrodes AE of the plurality of subpixels SP1, SP2, SP3 and SP4 in parallel in the first direction (or X-axis direction). For example, the non-opening bank portion NBA may be configured to extend from a lower end edge of the pixel electrode AE in the second direction toward a center portion of the pixel electrode AE. The non-opening bank portion NBA of the plurality of subpixels SP1, SP2, SP3 and SP4 may have regions that overlap with the pixel electrodes AE of the plurality of subpixels SP1, SP2, SP3 and SP4, which may be different from each other. For example, the non-opening bank portion NBA of the second subpixel SP2 may be configured to have a region that overlaps with the pixel electrode AE to a greater extent than the non-opening bank portions NBA of the other subpixels SP1, SP3 and SP4, but embodiments of the present disclosure are not limited thereto. For example, the non-opening bank portion NBA may cover a portion of the pixel electrode AE, thereby reducing the aperture ratio of the light emitting portion. Also, the non-opening bank portion NBA may absorb a portion of internal light that is reflected back from the common electrode CE through the pixel electrode AE, thereby reducing the cell reflectance of the light emitting portion.

The at least one color filter CF1, CF3 and CF4 may be disposed so as to overlap the non-opening area NOA of the pixel electrode AE. For example, the at least one color filter CF1, CF3 and CF4 may be disposed below the non-opening bank portion NBA. For example, the non-opening bank portion NBA may overlap with the at least one color filter CF1, CF3 and CF4. The non-opening bank portion NBA of the plurality of subpixels SP1, SP2, SP3 and SP4 may have areas that overlap with the at least one color filter CF1, CF3 and CF4, which may differ from each other, but embodiments of the present disclosure are not limited thereto. For example, the non-opening bank portion NBA of the second subpixel SP2 may overlap with the corresponding pixel electrode AE, and the non-opening bank portion NBA of the other subpixels SP1, SP3 and SP4 may overlap with the corresponding pixel electrode AE and the at least one color filter CF1, CF3 and CF4. For example, the at least one color filter CF1, CF3 and CF4 overlapping with the non-opening bank portion NBA may absorb a portion of external light incident from outside before reaching the pixel electrode AE, thereby further reducing the cell reflectance of the light emitting portion.

According to another embodiment of the present disclosure, the non-opening bank portions NBA of the plurality of subpixels SP1, SP2, SP3 and SP4 may be configured to extend from the bank portion BA of the non-emission area NEA toward central portions of the pixel electrode AE of the corresponding subpixels SP1, SP2, SP3 and SP4 to define the non-opening areas NOA of the pixel electrode AE, and may be configured to overlap with the at least one color filter CF1, CF3 and CF4 in the non-opening area NOA, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

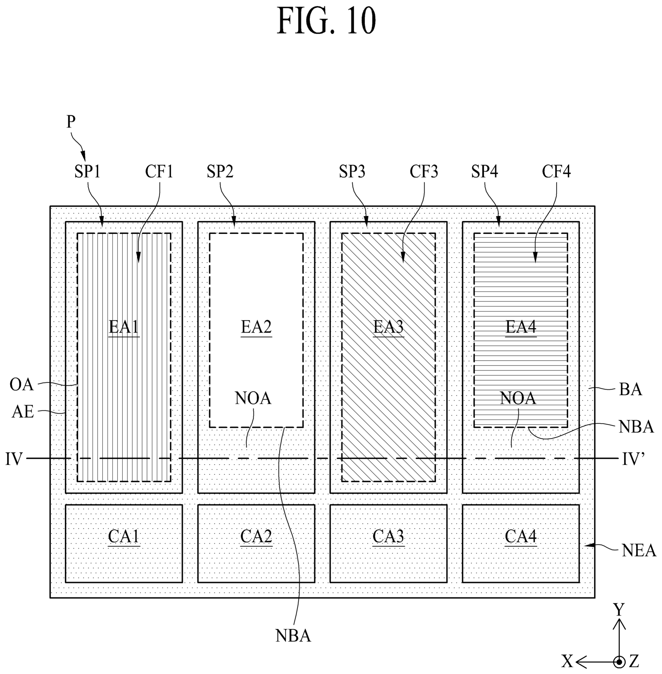

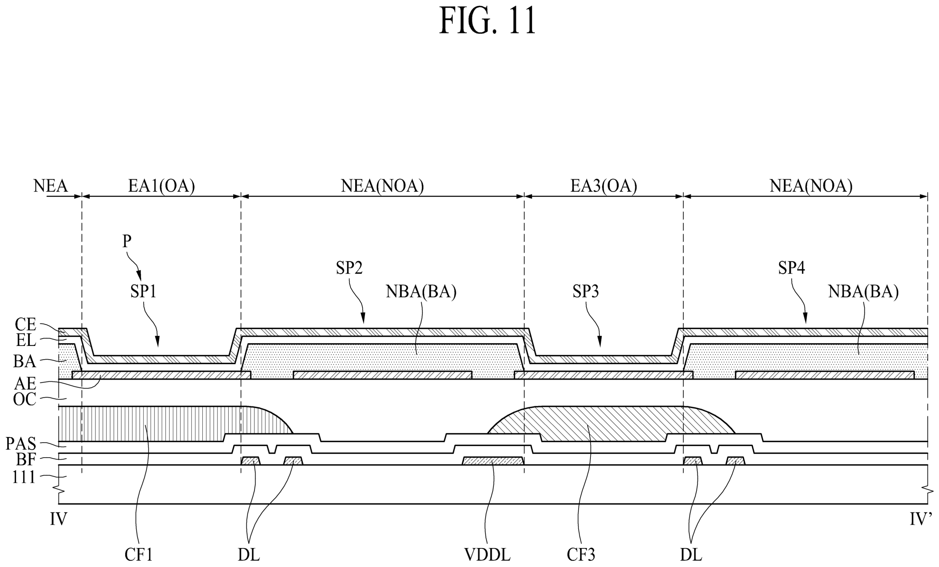

FIG. 10 illustrates a bank portion and a color filter of a pixel according to another embodiment of the present disclosure. FIG. 11 is a cross-sectional view taken along line IV-IV' of FIG. 10 according to another embodiment of the present disclosure. FIGS. 10 and 11 illustrate embodiments of the present disclosure in which a configuration of the bank portion and the color filter is modified in the light emitting display apparatus described with reference to FIGS. 1 to 9. In the following description referring to FIGS. 10 and 11, the same reference numerals will be used for the same components, except for the modified configurations, and their redundant descriptions will be omitted or briefly described.

Referring to FIGS. 10 and 11, the light emitting display apparatus according to another embodiment of the present disclosure may be configured such that the bank portion BA of the at least one of the subpixels SP1, SP2, SP3 and SP4 extends toward a central portion of the pixel electrode AE in a second direction (or a Y-axis direction) intersecting a first direction (or an X-axis direction) to define the non-opening area NOA of the pixel electrode AE.

The non-opening bank portion NBA of the bank portion BA of at least one subpixel SP2 and SP4 may be disposed in the non-opening area NOA of the pixel electrode AE. For example, the non-opening bank portion NBA may be disposed between the pixel electrode AE and the organic emission layer EL. For example, the non-opening bank portion NBA may be disposed in the second subpixel SP2 and the fourth subpixel SP4, and may not be disposed in the first subpixel SP1 and the third subpixel SP3. For example, the non-opening bank portion NBA may be configured to extend from a lower end edge of the respective pixel electrode AE of the second subpixel SP2 and the fourth subpixel SP4 in the second direction toward a center portion of the pixel electrode AE. For example, the non-opening bank portions NBA of the second subpixel SP2 and the fourth subpixel SP4 may be configured to extend in the second direction toward a central portion of the pixel electrode AE further than the bank portions BA of the first subpixel SP1 and the third subpixel SP3.

Referring to FIG. 10, the non-opening bank portion NBA may not be disposed in the first subpixel SP1 and the third subpixel SP3, and may be disposed in the second subpixel SP2 and the fourth subpixel SP4. Accordingly, the emission areas EA1 and EA3 of the first subpixel SP1 and the third subpixel SP3 may be configured to have a larger area than the emission areas EA2 and EA4 of the second subpixel SP2 and the fourth subpixel SP4.

The at least one color filter CF1, CF3 and CF4 may be disposed not to overlap the non-opening area NOA of the pixel electrode AE. For example, a color filter may not be disposed in the second subpixel SP2, and the fourth color filter CF4 may not be disposed on the non-opening bank portion NBA of the fourth subpixel SP4.

According to another embodiment of the present disclosure, the non-opening bank portions NBA of the second and fourth subpixels SP2 and SP4 may be configured to extend from the bank portions BA of the non-emission areas NEA toward center portions of the pixel electrodes AE of the corresponding subpixels SP2 and SP4 to define the non-opening areas NOA of the pixel electrodes AE, and the first and third subpixels SP1 and SP3 may be configured not to include the non-opening bank portion NBA, thereby optimizing the aperture ratios of the emission areas EA1, EA2, EA3 and EA4 while minimizing or reducing additional mask processes. Accordingly, the light emitting display apparatus according to another embodiment of the present disclosure may reduce the reflectance increased by not using a polarizer, and may improve light efficiency.

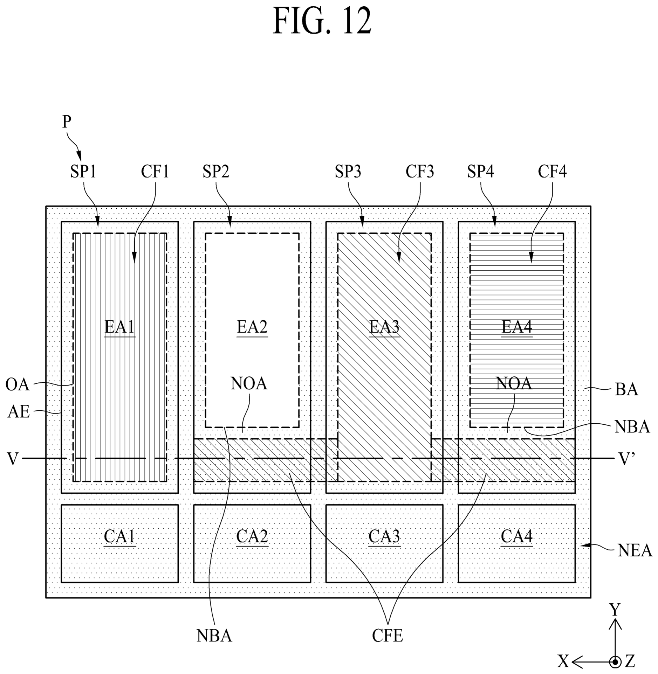

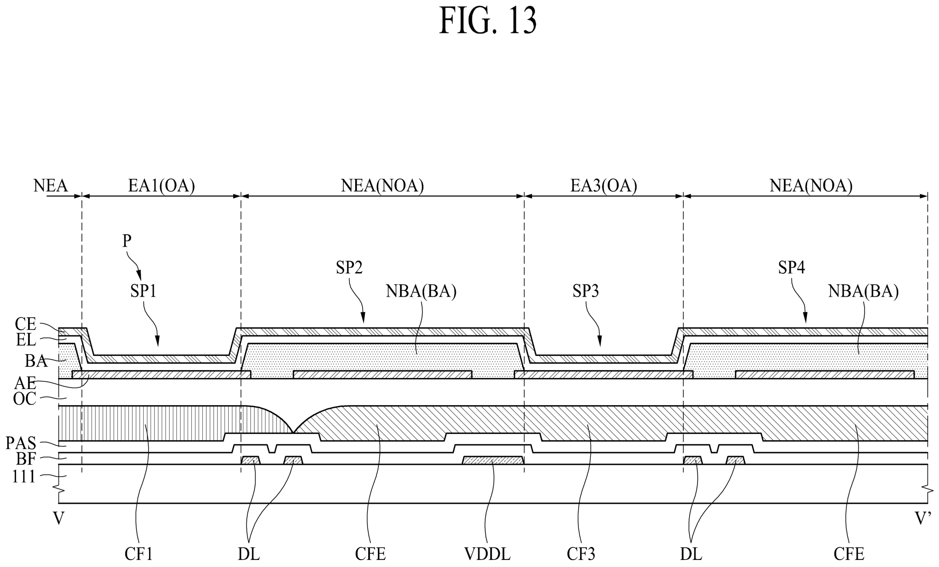

FIG. 12 illustrates a bank portion and a color filter of a pixel according to another embodiment of the present disclosure. FIG. 13 is a cross-sectional view taken along line V-V' of FIG. 12 according to another embodiment of the present disclosure. FIGS. 12 and 13 illustrate embodiments of the present disclosure in which a configuration of the bank portion and the color filter is modified in the light emitting display apparatus described with reference to FIGS. 1 to 11. For example, FIGS. 12 and 13 illustrate configurations in which the configuration of the color filters is modified in the light emitting display apparatus described with reference to FIGS. 10 and 11. In the following description referring to FIGS. 12 and 13, the same reference numerals will be used for the same components, except for the modified configurations, and their redundant descriptions will be omitted or briefly described.

Referring to FIGS. 12 and 13, the light emitting display apparatus according to another embodiment of the present disclosure may be configured such that the bank portion BA of the at least one of the subpixels SP1, SP2, SP3 and SP4 extends toward a central portion of the pixel electrode AE in a second direction (or a Y-axis direction) intersecting a first direction (or an X-axis direction) to define the non-opening area NOA of the pixel electrode AE.

At least one of the first subpixel SP1 and the third subpixel SP3 adjacent to the second subpixel SP2 may be disposed such that at least a portion of the color filters CF1 and CF3 extends in the first direction (or X-axis direction) to overlap the second subpixel SP2. For example, at least a portion of the first color filter CF1 of the first subpixel SP1 may be disposed to extend in the first direction and overlap the non-opening bank portion NBA of the second subpixel SP2. At least a portion of the third color filter CF3 of the third subpixel SP3 may be disposed to extend in the first direction and overlap the non-opening bank portion NBA of the second subpixel SP2.

According to another embodiment of the present disclosure, at least a portion of the third color filter CF3 of the third subpixel SP3 may include the color filter extension portion CFE extending in the first direction. The color filter extension portion CFE of the third subpixel SP3 may extend in the first direction to the adjacent second subpixel SP2 and may be disposed to overlap the non-opening bank portion NBA of the second subpixel SP2. The color filter extension portion CFE of the third subpixel SP3 may extend in the first direction to the adjacent fourth subpixel SP4 and may be disposed to overlap the non-opening bank portion NBA of the fourth subpixel SP4. The fourth color filter CF4 may not be disposed in the non-opening bank portion NBA of the fourth subpixel SP4, or the fourth color filter CF4 may be disposed in the non-opening bank portion NBA of the fourth subpixel SP4. For example, the color filter extension portion CFE of the third subpixel SP3 may overlap the fourth color filter CF4 in the non-opening bank portion NBA of the fourth subpixel SP4. For example, the color filter extension portion CFE overlapping the non-opening bank portion NBA may absorb a portion of external light incident from outside before reaching the pixel electrode AE, thereby further reducing the cell reflectance of the light emitting portion.

Referring to FIG. 12, the non-opening bank portion NBA may not be disposed in the first and third subpixels SP1 and SP3, and may be disposed in the second and fourth subpixels SP2 and SP4. Accordingly, the emission areas EA1 and EA3 of the first and third subpixels SP1 and SP3 may be configured to have larger area than the emission areas EA2 and EA4 of the second and fourth subpixels SP2 and SP4.

Referring to FIG. 13, the color filter extension portion CFE of the third subpixel SP3 may be disposed in the non-opening bank portion NBA of the second subpixel SP2 and the non-opening bank portion NBA of the fourth subpixel SP4. For example, the color filter extension portion CFE disposed in the second subpixel SP2 may overlap the pixel electrode AE of the second subpixel SP2, and may not overlap the emission area EA2 of the second subpixel SP2. For example, the color filter extension portion CFE disposed in the fourth subpixel SP4 may overlap the pixel electrode AE of the fourth subpixel SP4, and may not overlap the emission area EA4 of the fourth subpixel SP4. Also, the color filter extension portion CFE disposed in the fourth subpixel SP4 may be disposed in parallel with the color filter CF4 of the fourth subpixel SP4 in the first direction (or X-axis direction). For example, in the fourth subpixel SP4, the color filter CF4 may be disposed in the emission area EA4, and the color filter extension portion CFE of the third subpixel SP3 may be disposed in the non-opening area NOA.

According to another embodiment of the present disclosure, the non-opening bank portions NBA of the second subpixel SP2 and the fourth subpixel SP4 may be configured to extend from the bank portion BA of the non-emission area NEA toward central portions of the pixel electrode AE of the corresponding subpixels SP2 and SP4 to define the non-opening areas NOA of the pixel electrode AE, the first and third subpixels SP1 and SP3 may be configured not to include the non-opening bank portion NBA, and the color filter CF3 of the third subpixel SP3 may be configured to extend to adjacent other subpixels SP2 and SP4, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

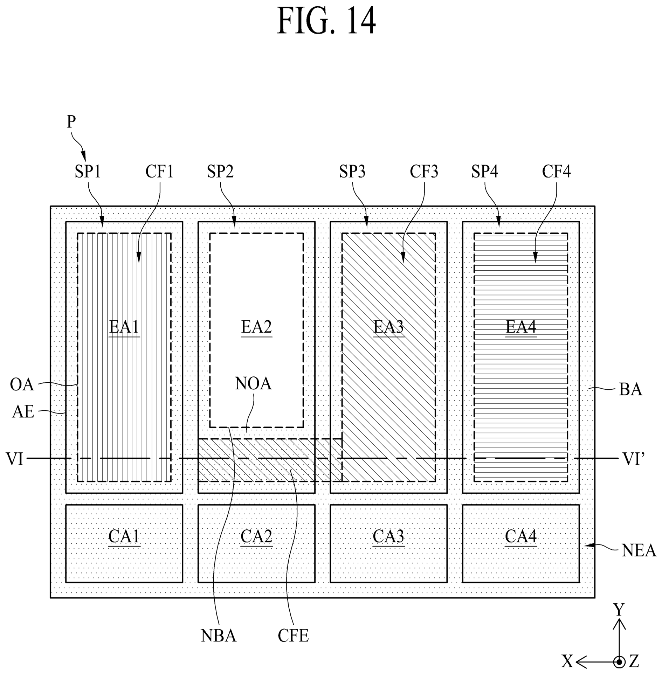

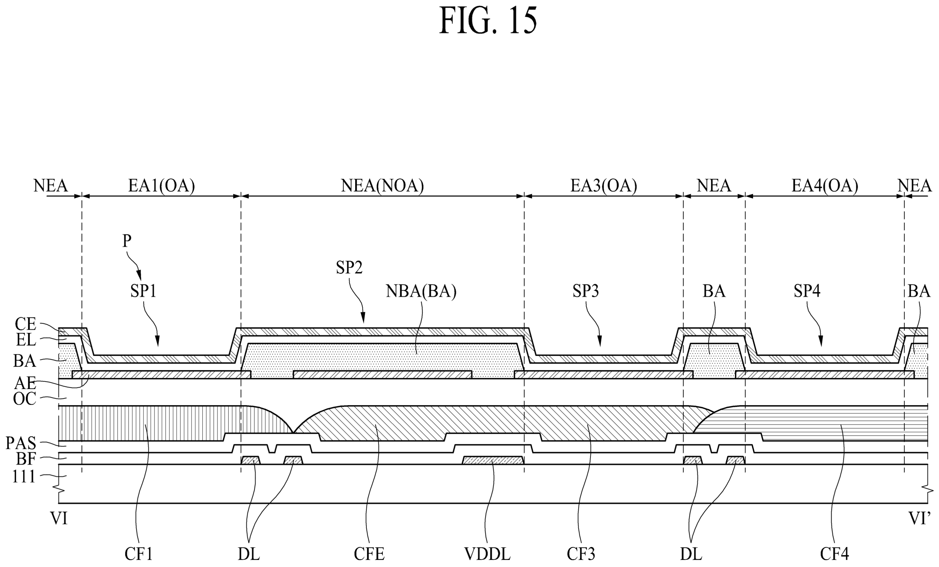

FIG. 14 illustrates a bank portion and a color filter of a pixel according to another embodiment of the present disclosure. FIG. 15 is a cross-sectional view taken along line VI-VI' of FIG. 14 according to another embodiment of the present disclosure. FIGS. 14 and 15 illustrate embodiments of the present disclosure in which a configuration of the bank portion and the color filter is modified in the light emitting display apparatus described with reference to FIGS. 1 to 13. For example, FIGS. 14 and 15 illustrate configurations in which the configuration of the color filters is modified in the light emitting display apparatus described with reference to FIGS. 12 and 13. In the following description referring to FIGS. 14 and 15, the same reference numerals will be used for the same components, except for the modified configurations, and their redundant descriptions will be omitted or briefly described.

Referring to FIGS. 14 and 15, the light emitting display apparatus according to another embodiment of the present disclosure may be configured such that the bank portion BA of at least one subpixel SP2 extends toward a central portion of the pixel electrode AE in a second direction (or a Y-axis direction) intersecting a first direction (or an X-axis direction) to define the non-opening area NOA of the pixel electrode AE.

The non-opening bank portion NBA of the bank portion BA of the second subpixel SP2 may be disposed in the non-opening area NOA of the pixel electrode AE. For example, the non-opening bank portion NBA may be configured to extend in the second direction from a lower end edge of the pixel electrode AE of the second subpixel SP2 toward a central portion of the pixel electrode AE. For example, the non-opening bank portion NBA of the second subpixel SP2 may be configured to extend to the central portion of the pixel electrode AE in the second direction farther than the bank portions BA of the first subpixel SP1, the third subpixel SP3, and the fourth subpixel SP4.

At least one of the first subpixel SP1 and the third subpixel SP3 adjacent to the second subpixel SP2 may be configured such that at least a portion of the color filters CF1 and CF3 extends in the first direction (or X-axis direction) to overlap with the second subpixel SP2.

According to another embodiment of the present disclosure, at least a portion of the third color filter CF3 of the third subpixel SP3 may include the color filter extension portion CFE that extends in the first direction. The color filter extension portion CFE of the third subpixel SP3 may extend in the first direction to the adjacent second subpixel SP2 and may be disposed to overlap the non-opening bank portion NBA of the second subpixel SP2. For example, the color filter extension portion CFE overlapping with the non-opening bank portion NBA may absorb a portion of external light incident from outside before reaching the pixel electrode AE, thereby further reducing the cell reflectance of the light emitting portion.

Referring to FIG. 14, the non-opening bank portion NBA may not be disposed in the first subpixel SP1, the third subpixel SP3, and the fourth subpixel SP4, but may be disposed in the second subpixel SP2. Accordingly, the emission area EA2 of the second subpixel SP2 may be configured to have a smaller area than the emission areas EA1, EA3 and EA4 of the other subpixels SP1, SP3 and SP4.

Referring to FIG. 15, the color filter extension portion CFE of the third subpixel SP3 may be disposed in the non-opening bank portion NBA of the second subpixel SP2. For example, the color filter extension portion CFE of the third subpixel SP3 disposed in the second subpixel SP2 may overlap the pixel electrode AE of the second subpixel SP2 and may not overlap the emission area EA2 of the second subpixel SP2.

According to another embodiment of the present disclosure, the non-opening bank portion NBA of the second subpixel SP2 may be configured to extend from the bank portion BA of the non-emission area NEA toward a central portion of the pixel electrode AE of the corresponding subpixel SP2 to define the non-opening area NOA of the pixel electrode AE, the first, third and fourth subpixels SP1, SP3 and SP4 may not include the non-opening bank portion NBA, and the color filter CF3 of the third subpixel SP3 may be configured to extend to the second subpixel SP2, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

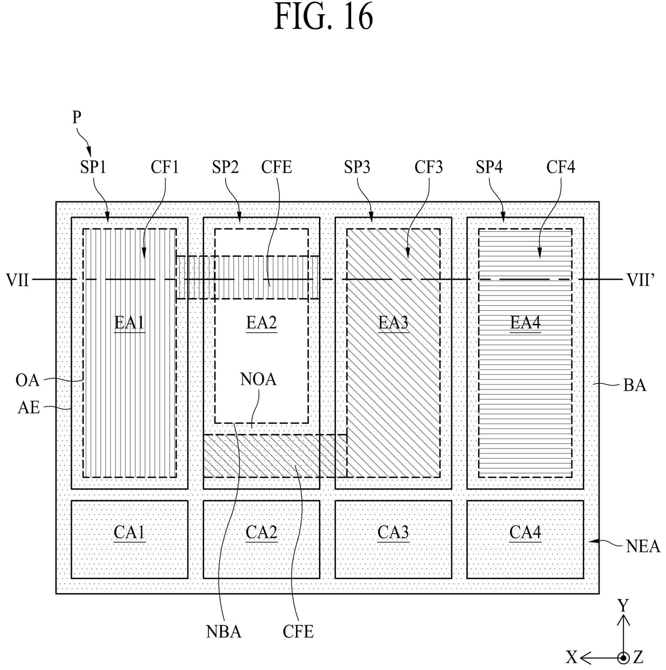

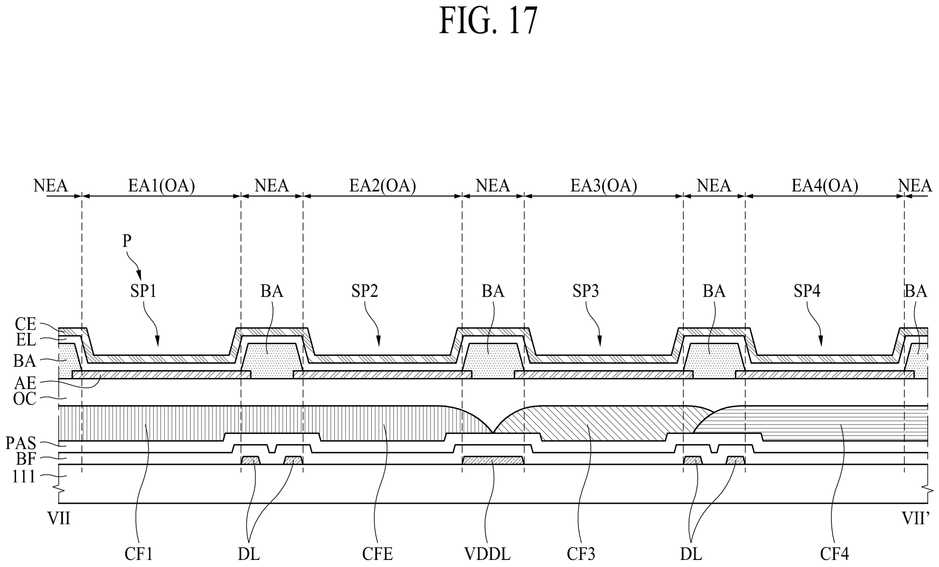

FIG. 16 illustrates a bank portion and a color filter of a pixel according to another embodiment of the present disclosure. FIG. 17 is a cross-sectional view taken along line VII-VII' of FIG. 16 according to another embodiment of the present disclosure. FIGS. 16 and 17 illustrate embodiments of the present disclosure in which a configuration of the bank portion and the color filter is modified in the light emitting display apparatus described with reference to FIGS. 1 to 15. In the following description referring to FIGS. 16 and 17, the same reference numerals will be used for the same components, except for the modified configurations, and their redundant descriptions will be omitted or briefly described.

Referring to FIGS. 16 and 17, the light emitting display apparatus according to another embodiment of the present disclosure may be configured such that the bank portion BA of at least one subpixel SP2 extends in a second direction (or Y-axis direction) intersecting a first direction (or X-axis direction) toward a central portion of the pixel electrode AE to define a non-opening area NOA of the pixel electrode AE.

At least a portion of the color filters CF1 and CF3 of the first subpixel SP1 and the third subpixel SP3 adjacent to the second subpixel SP2 may be disposed to extend in the first direction (or X-axis direction) and overlap the second subpixel SP2.

According to another embodiment of the present disclosure, at least a portion of the first color filter CF1 of the first subpixel SP1 may include the color filter extension portion CFE extending in the first direction, and at least a portion of the third color filter CF3 of the third subpixel SP3 may include the color filter extension portion CFE extending in the first direction. For example, the color filter extension portions CFE of the first subpixel SP1 and the third subpixel SP3 may overlap the pixel electrode AE of the second subpixel SP2. For example, the color filter extension portion CFE of the first subpixel SP1 may be disposed to overlap the opening area OA of the pixel electrode AE of the second subpixel SP2, and the color filter extension portion CFE of the third subpixel SP3 may be disposed to overlap the non-opening area NOA of the pixel electrode AE of the second subpixel SP2. For example, the color filter extension portion CFE of the third subpixel SP3 may overlap the non-opening bank portion NBA of the second subpixel SP2. Alternatively, the color filter extension portion CFE of the first subpixel SP1 may be disposed to overlap the non-opening area NOA of the pixel electrode AE of the second subpixel SP2, and the color filter extension portion CFE of the third subpixel SP3 may be disposed to overlap the opening area OA of the pixel electrode AE of the second subpixel SP2. For example, the color filter extension portion CFE of the first subpixel SP1 may overlap the non-opening bank portion NBA of the second subpixel SP2. For example, the color filter extension portion CFE of the first subpixel SP1, which is disposed in the second emission area EA2, and the color filter extension portion CFE of the third subpixel SP3, which overlaps the non-opening bank portion NBA, may absorb a portion of the external light incident from outside before reaching the pixel electrode AE, thereby further reducing the cell reflectance of the light emitting portion.

Referring to FIG. 16, the non-opening bank portion NBA may not be disposed in the first subpixel SP1, the third subpixel SP3, and the fourth subpixel SP4, but may be disposed in the second subpixel SP2. Accordingly, the emission area EA2 of the second subpixel SP2 may be configured to have a smaller area than the emission areas EA1, EA3 and EA4 of the other subpixels SP1, SP3 and SP4.

Referring to FIG. 17 in conjunction with FIG. 15, the color filter extension portion CFE of the third subpixel SP3 may be disposed in the non-opening bank portion NBA of the second subpixel SP2. For example, the color filter extension portion CFE of the third subpixel SP3 disposed in the second subpixel SP2 may overlap the pixel electrode AE of the second subpixel SP2, and may not overlap the emission area EA2 of the second subpixel SP2. The color filter extension portion CFE of the first subpixel SP1 may be disposed in the emission area EA2 of the second subpixel SP2. For example, the color filter extension portion CFE of the first subpixel SP1 disposed in the second subpixel SP2 may overlap the pixel electrode AE of the second subpixel SP2, and may overlap the emission area EA2 of the second subpixel SP2.

According to another embodiment of the present disclosure, the non-opening bank portion NBA of the second subpixel SP2 may be configured to extend from the bank portion BA of the non-emission area NEA toward a central portion of the pixel electrode AE of the corresponding subpixel SP2 to define the non-opening area NOA of the pixel electrode AE, the first subpixel SP1, the third subpixel SP3 and the fourth subpixel SP4 may be configured not to include the non-opening bank portion NBA, and the color filters CF1 and CF3 of the first subpixel SP1 and the third subpixel SP3 may be configured to extend to the second subpixel SP2, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

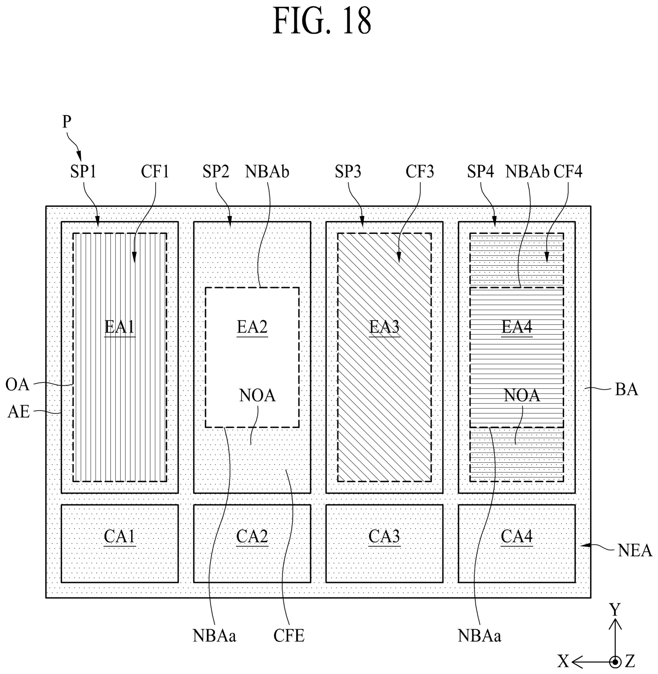

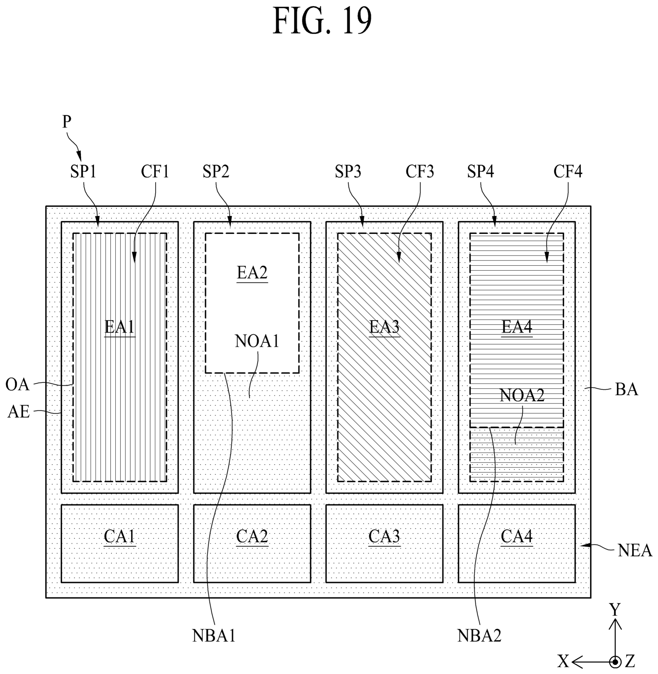

FIG. 18 illustrates a bank portion and a color filter of a pixel according to another embodiment of the present disclosure. FIG. 19 illustrates a bank portion and a color filter of a pixel according to another embodiment of the present disclosure. FIGS. 18 and 19 illustrate embodiments of the present disclosure in which a configuration of the bank portion and the color filter is modified in the light emitting display apparatus described with reference to FIGS. 1 to 17. In the following description referring to FIGS. 18 and 19, the same reference numerals will be used for the same components, except for the modified configurations, and their redundant descriptions will be omitted or briefly described.

Referring to FIG. 18, the light emitting display apparatus according to another embodiment of the present disclosure may be configured such that the bank portion BA of at least one subpixel SP2 and SP4 may include the first sub non-opening bank portion NBAa and the second sub non-opening bank portion NBAb spaced apart from each other in a second direction (or a Y-axis direction) with the opening area OA of the pixel electrode AE interposed therebetween.

The first sub non-opening bank portion NBAa may extend in the second direction from a lower end edge of the pixel electrode AE toward a central portion of the pixel electrode AE, and the second sub non-opening bank portion NBAb may extend in the second direction from an upper end edge of the pixel electrode AE toward the central portion of the pixel electrode AE. The first and second sub non-opening bank portion NBAa and NBAb may not be disposed in the first subpixel SP1 and the third subpixel SP3, but may be disposed in the second subpixel SP2 and the fourth subpixel SP4.

The first and second sub non-opening bank portions NBAa and NBAb may not be disposed in the first subpixel SP1 and the third subpixel SP3, but may be disposed in the second subpixel SP2 and the fourth subpixel SP4. Accordingly, the emission areas EA2 and EA4 of the second and fourth subpixels SP2 and SP4 may be configured to have larger area than the emission areas EA1 and EA3 of the first and third subpixels SP1 and SP3. For example, the first and second sub non-opening bank portions NBAa and NBAb of the second subpixel SP2 may overlap the pixel electrode AE of the second subpixel SP2. For example, the first and second sub non-opening bank portions NBAa and NBAb of the fourth subpixel SP4 may overlap the pixel electrode AE of the fourth subpixel SP4 and may overlap the color filter CF4 of the fourth subpixel SP4.

According to another embodiment of the present disclosure, the first and second sub non-opening bank portions NBAa and NBAb may be disposed in the second subpixel SP2 and the fourth subpixel SP4, may not be disposed in the first subpixel SP1 and the third subpixel SP3, and the color filter CF4 of the fourth subpixel SP4 may be configured to overlap with the first and second sub non-opening bank portions NBAa and NBAb, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

Referring to FIG. 19, the light emitting display apparatus according to another embodiment of the present disclosure may include the first non-opening bank portion NBA1 and the second non-opening bank portion NBA2.

The first non-opening bank portion NBA1 may be disposed in the non-opening area NOA of the pixel electrode AE of the second subpixel SP2, and the second non-opening bank portion NBA2 may be disposed in the non-opening area NOA of the pixel electrode AE of the fourth subpixel SP4. For example, the first non-opening bank portion NBA1 and the second non-opening bank portion NBA2 may be configured in different shapes. For example, the first non-opening bank portion NBA1 may be configured to extend in the second direction to the center of the pixel electrode AE further than the second non-opening bank portion NBA2.

The first non-opening bank portion NBA1 and the second non-opening bank portion NBA2 may not be disposed in the first subpixel SP1 and the third subpixel SP3. The first non-opening bank portion NBA1 may be disposed in the second subpixel SP2, and the second non-opening bank portion NBA2 may be disposed in the fourth subpixel SP4. Also, an area in which the first non-opening bank portion NBA1 overlaps the pixel electrode AE of the second subpixel SP2 may be configured to have larger area than an area in which the second non-opening bank portion NBA2 overlaps the pixel electrode AE of the fourth subpixel SP4. Accordingly, the emission areas EA1 and EA3 of the first subpixel SP1 and the third subpixel SP3 may be configured to have a larger area than the emission areas EA2 and EA4 of the second subpixel SP2 and the fourth subpixel SP4, and the emission area EA2 of the second subpixel SP2 may be configured to have a smaller area than the emission area EA4 of the fourth subpixel SP4. For example, the first non-opening bank portion NBA1 of the second subpixel SP2 may overlap the pixel electrode AE of the second subpixel SP2. For example, the second non-opening bank portion NBA2 of the fourth subpixel SP4 may overlap the pixel electrode AE of the fourth subpixel SP4, and may overlap the color filter CF4 of the fourth subpixel SP4.

According to another embodiment of the present disclosure, the first and second non-opening bank portions NBA1 and NBA2 may be disposed in the second subpixel SP2 and the fourth subpixel SP4, may not be disposed in the first subpixel SP1 and the third subpixel SP3, and the color filter CF4 of the fourth subpixel SP4 may be configured to overlap with the second non-opening bank portion NBA2, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

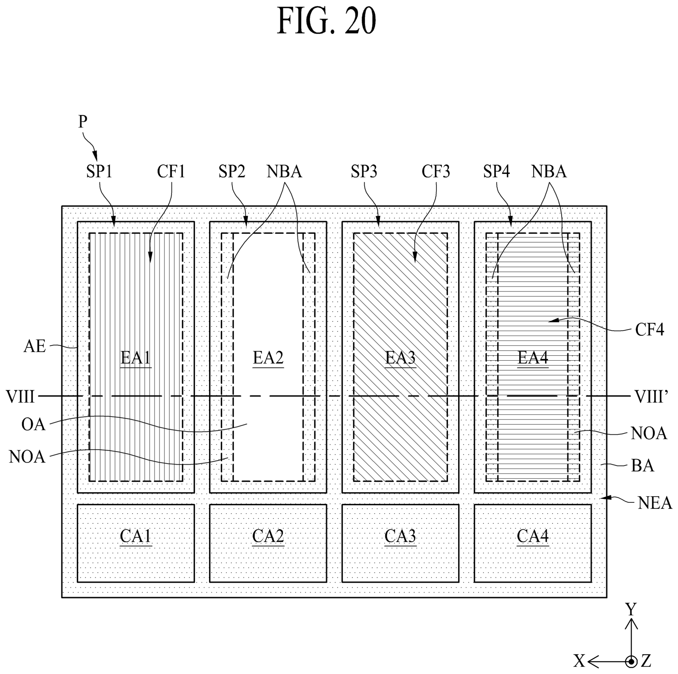

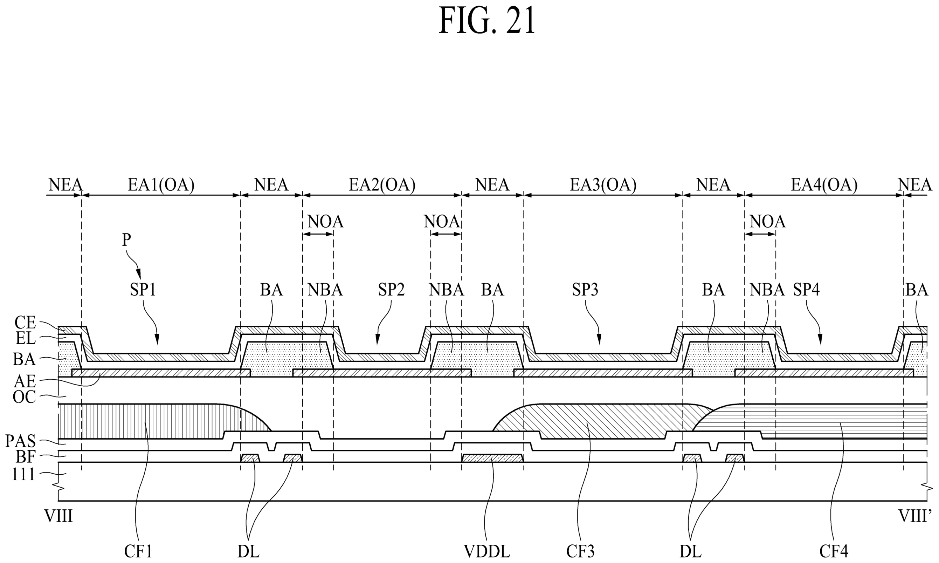

FIG. 20 illustrates a bank portion and a color filter of a pixel according to another embodiment of the present disclosure. FIG. 21 is a cross-sectional view taken along line VIII-VIII' of FIG. 20 according to another embodiment of the present disclosure. FIGS. 20 and 21 illustrate embodiments of the present disclosure in which a configuration of the bank portion and the color filter is modified in the light emitting display apparatus described with reference to FIGS. 1 to 19. In the following description referring to FIGS. 20 and 21, the same reference numerals will be used for the same components, except for the modified configurations, and their redundant descriptions will be omitted or briefly described.

Referring to FIGS. 20 and 21, the light emitting display apparatus according to another embodiment of the present disclosure may be configured such that the bank portion BA disposed between the plurality of subpixels SP1, SP2, SP3 and SP4 extends in a first direction (or an X-axis direction) toward a central portion of the pixel electrode AE to define the non-opening area NOA of the pixel electrode AE. For example, the bank portions BA adjacent to the second subpixel SP2 and the fourth subpixel SP4 may include the non-opening bank portion NBA disposed in the non-opening area NOA of the pixel electrodes AE of the second subpixel SP2 and the fourth subpixel SP4 in the first direction. For example, the non-opening bank portion NBA may be configured to extend in the first direction from both lateral end edges of the pixel electrodes AE of the second subpixel SP2 and the fourth subpixel SP4 toward the central portion of the pixel electrode AE.

The non-opening bank portion NBA of the second subpixel SP2 may extend from the bank portion BA between the first subpixel SP1 and the second subpixel SP2 toward a central portion of the pixel electrode AE of the second subpixel SP2. Alternatively or additionally, the non-opening bank portion NBA of the second subpixel SP2 may extend from the bank portion BA between the second subpixel SP2 and the third subpixel SP3 toward the central portion of the pixel electrode AE of the second subpixel SP2 to define a non-opening area NOA of the pixel electrode AE. For example, the non-opening bank portion NBA of the fourth subpixel SP4 may extend from the bank portion BA between the third subpixel SP3 and the fourth subpixel SP4 toward a central portion of the pixel electrode AE of the fourth subpixel SP4. Alternatively or additionally, the non-opening bank portion NBA of the fourth subpixel SP4 may extend from the main body portion of the bank portion BA between the fourth subpixel SP4 and an adjacent other pixel SP toward the central portion of the pixel electrode AE of the fourth subpixel SP4 to define a non-opening area NOA of the pixel electrode AE. Accordingly, the emission areas EA2 and EA4 of the second subpixel SP2 and the fourth subpixel SP4 may be configured to have a smaller area than the emission areas EA1 and EA3 of the first subpixel SP1 and the third subpixel SP3. For example, the non-opening bank portion NBA of the second subpixel SP2 may overlap the pixel electrode AE of the second subpixel SP2. For example, the non-opening bank portion NBA of the fourth subpixel SP4 may overlap the pixel electrode AE of the fourth subpixel SP4 and may overlap the color filter CF4 of the fourth subpixel SP4.

According to another embodiment of the present disclosure, the non-opening bank portions NBA of the second subpixel SP2 and the fourth subpixel SP4 may extend from the bank portion BA between the subpixels toward the center portion of the pixel electrode AE of the corresponding subpixel SP2 and SP4 to define a non-opening area NOA of the pixel electrode AE, and the first subpixel SP1 and the third subpixel SP3 may be configured not to include the non-opening bank portion NBA, thereby optimizing the aperture ratios and reflective color of the emission areas EA1, EA2, EA3 and EA4 while minimizing or reducing additional mask processes. Accordingly, the light emitting display apparatus according to another embodiment of the present disclosure may reduce the reflectance increased by not using a polarizer, improve light efficiency, and enhance reflective color and visibility perception.

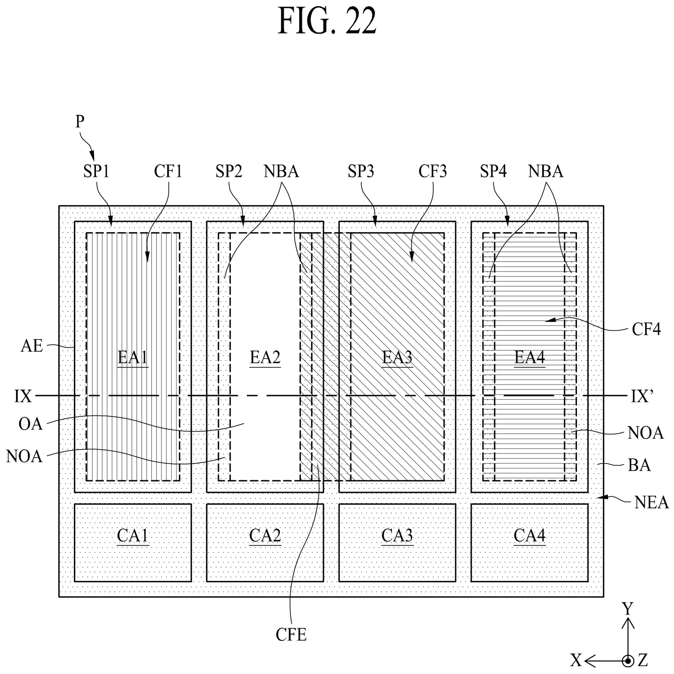

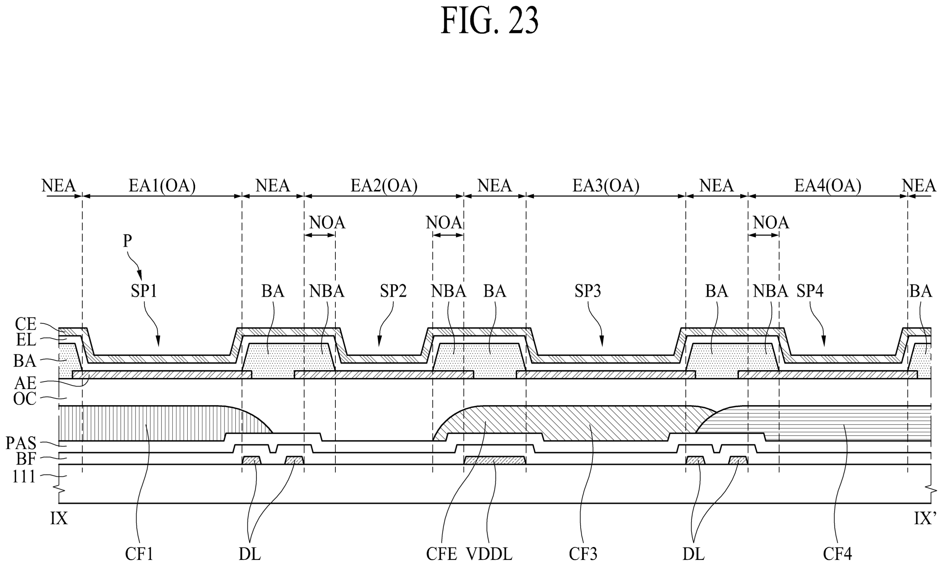

FIG. 22 illustrates a bank portion and a color filter of a pixel according to another embodiment of the present disclosure. FIG. 23 is a cross-sectional view taken along line IX-IX' of FIG. 22 according to another embodiment of the present disclosure. FIGS. 22 and 23 illustrate embodiments of the present disclosure in which a configuration of the bank portion and the color filter is modified in the light emitting display apparatus described with reference to FIGS. 1 to 21. In the following description referring to FIGS. 22 and 23, the same reference numerals will be used for the same components, except for the modified configurations, and their redundant descriptions will be omitted or briefly described.

Referring to FIGS. 22 and 23, the light emitting display apparatus according to another embodiment of the present disclosure may be configured such that the bank portion BA disposed between the plurality of subpixels SP1, SP2, SP3 and SP4 may extend in a first direction (or X-axis direction) toward a center portion of the pixel electrode AE to define the non-opening area NOA of the pixel electrode AE.

At least a portion of the color filters CF1 and CF3 of the first subpixel SP1 and the third subpixel SP3 which are adjacent to the second subpixel SP2 may extend in the first direction (or X-axis direction) and may be disposed to overlap with the second subpixel SP2. For example, at least a portion of the third color filter CF3 of the third subpixel SP3 may include the color filter extension portion CFE extending in the first direction. The color filter extension portion CFE of the third subpixel SP3 may be disposed to overlap with the non-opening bank portion NBA of the second subpixel SP2.

The non-opening bank portion NBA of the second subpixel SP2 may extend from the bank portion BA between the first subpixel SP1 and the second subpixel SP2 toward a central portion of the pixel electrode AE of the second subpixel SP2, and may extend from the bank portion BA between the second subpixel SP2 and the third subpixel SP3 toward the central portion of the pixel electrode AE of the second subpixel SP2, thereby defining the non-emission area NEA of the pixel electrode AE. For example, the non-opening bank portion NBA of the fourth subpixel SP4 may extend from the bank portion BA between the third subpixel SP3 and the fourth subpixel SP4 toward a central portion of the pixel electrode AE of the fourth subpixel SP4, and may extend from the bank portion BA between the fourth subpixel SP4 and an adjacent other pixel SP toward the central portion of the pixel electrode AE of the fourth subpixel SP4, thereby defining a non-emission area NEA of the pixel electrode AE. Accordingly, the emission areas EA2 and EA4 of the second subpixel SP2 and the fourth subpixel SP4 may have a smaller area than the emission areas EA1 and EA3 of the first subpixel SP1 and the third subpixel SP3.

The color filter extension portion CFE of the third subpixel SP3 may be disposed in the non-opening bank portion NBA of the second subpixel SP2. For example, the color filter extension portion CFE of the third subpixel SP3 may overlap the non-opening bank portion NAB disposed on the right side of the second subpixel SP2. The color filter extension portion CFE of the third subpixel SP3 may overlap the pixel electrode AE of the second subpixel SP2 and may not overlap the emission area EA2 of the second subpixel SP2.

According to another embodiment of the disclosure, the non- opening bank portions NBA of the second subpixel SP2 and the fourth subpixel SP4 may extend from the bank portions BA between the subpixels to the central portions of the pixel electrodes AE of the corresponding subpixels SP2 and SP4 to define the non-aperture areas NOA of the pixel electrodes AE. The first subpixel SP1 and the third subpixel SP3 may not include the non-opening bank portion NBA, and the color filter CF3 of the third subpixel SP3 may be configured to overlap the non-opening bank portion NBA of the second subpixel SP2, thereby optimizing the aperture ratios and reflective color of the emission areas EA1, EA2, EA3 and EA4 while minimizing or reducing additional mask processes. Accordingly, the light-emitting display apparatus according to another embodiment of the disclosure may reduce the reflectance increased by not using a polarizer, improve light efficiency, and enhance reflective color and visibility perception.

The above-described feature, structure, and effect of the present disclosure are included in at least one embodiment of the disclosure, but are not limited to only one embodiment. Furthermore, the feature, structure, and effect described in at least one embodiment of the disclosure may be implemented through combination or modification of other embodiments by those skilled in the art. Therefore, content associated with the combination and modification should be construed as being within the scope of the disclosure.

It will be apparent to those skilled in the art that various modifications and variations can be made in the present disclosure without departing from the scope of the disclosures. Thus, it is intended that the present disclosure covers the modifications and variations of this disclosure provided they come within the scope of the appended claims and their equivalents.

## Claims

1. A light emitting display apparatus comprising:
a substrate (111) including a plurality of subpixels (SP) arranged in a first direction, each of the plurality of subpixels (SP) including an emission area (EA) and a non-emission area (NEA);
at least one thin film transistor (DR, TR1, TR2) disposed in the non-emission area (NEA), wherein at least one protective layer (PAS) is disposed on the at least one thin film transistor (DR, TR1, TR2); and
at least one color filter (CF) disposed on the at least one protective layer (PAS), in at least some of the plurality of subpixels (SP),
wherein each of the plurality of subpixels (SP) includes a pixel electrode (AE), an emission layer (EL), a common electrode (CE), and a bank portion (BA) defining an opening area (OA) of the pixel electrode (AE), and
wherein, for at least one subpixel (SP) among the plurality of subpixels (SP), the bank portion (BA) further includes a non-opening bank portion (NBA) extending toward a center portion of the pixel electrode (AE) in the first direction or a second direction intersecting the first direction to define a non-opening area (NOA) of the pixel electrode (AE).

2. The light emitting display apparatus of claim 1, wherein the bank portion (BA) includes at least one of a light absorbing material and a black material.

3. The light emitting display apparatus of claim 1 or 2, wherein the opening area (OA) of the pixel electrode (AE) overlaps the emission area (EA), and the non-opening area (NOA) of the pixel electrode (AE) overlaps the non-emission area (NEA).

4. The light emitting display apparatus of any one of the preceding claims, wherein the non-opening bank portion (NBA) is disposed between the pixel electrode (AE) and the emission layer (EL) and/or the non-opening bank portion (NOA) is disposed over the pixel electrodes (AE) of the plurality of subpixels (SP) parallel to the first direction.

5. The light emitting display apparatus of any one of the preceding claims, wherein for at least one other subpixel (SP) among the plurality of subpixels, the bank portion (BA) is devoid of the non-opening bank portion (NBA), and/or the non-opening bank portion (NBA) of the at least one subpixel (SP) extends toward the center portion of the pixel electrode (AE) in the first direction or the second direction more than the bank portion (BA) of the at least one other subpixel (SP).

6. The light emitting display apparatus of any one of the preceding claims wherein the non-opening bank portion (NBA) includes a first sub non-opening bank portion (NBAa) and a second sub non-opening bank portion (NBAb) spaced apart from each other in the second direction with the opening area (OA) of the pixel electrode (AE) interposed therebetween.

7. The light emitting display apparatus of any one of the preceding claims, wherein the non-opening bank portion (NBA) of the bank portion (BA) of the at least one subpixel (SP) is a first non-opening bank portion (NBA1), and
wherein the bank portion (BA) of at least one other subpixel (SP) among the plurality of subpixels includes a second non-opening bank portion (NBA2) different from the first non-opening bank portion (NBA1), preferably the first non-opening bank portion (NBA1) extends toward the center portion of the pixel electrode (AE) in the second direction more than the second non-opening bank portion (NBA2).

8. The light emitting display apparatus of any one of the preceding claims, wherein the at least one color filter (CF) is disposed to overlap with the non-opening area (NOA) of the pixel electrode (AE).

9. The light emitting display apparatus of any one of the preceding claims, wherein the plurality of subpixels (SP) include a first subpixel (SP1), a second subpixel (SP2), a third subpixel (SP3), and a fourth subpixel (SP4), and
wherein the non-opening bank portion (NBA) extends toward the center portion of the pixel electrode (AE) of each of the first to fourth subpixels (SP1-SP4) in the second direction,
preferably the second subpixel (SP2) is a white subpixel in which the at least one color filter (CF) is not disposed, and
wherein color filters (CF) of the first, third, and fourth subpixels (SP1, SP3, SP4), among the at least one color filter (CF), are disposed to overlap with the non-opening bank portion (NBA).

10. The light emitting display apparatus of claim 9, wherein at least one of the first subpixel (SP1) and the third subpixel (SP3) adjacent to the second subpixel (SP2) is disposed such that at least a portion of the color filter (CFl, CF3) of the at least one of the first subpixel (SP1) and the third subpixel (SP3) extends in the first direction to overlap with the second subpixel (SP2),
preferably the color filter (CF) overlapping the second subpixel (SP2) is disposed to overlap with either the non-opening bank portion (NBA) of the second subpixel (SP2) or the opening area (OA) of the second subpixel (SP2).

11. The light emitting display apparatus of claim 9 or 10, wherein the first subpixel (SP1) is a red subpixel, the third subpixel (SP3) is a blue subpixel, and the fourth subpixel (SP2) is a green subpixel.

12. The light emitting display apparatus of claim 9, 10 or 11, wherein the third subpixel (SP3) is between the second subpixel (SP2) and the fourth subpixel (SP4) in first direction, wherein at least a portion of the color filter (CF3) of the third subpixel (SP3) extends in first direction to overlap with the second subpixel (SP2) and the fourth subpixel (SP4).

13. The light emitting display apparatus of claim 12, wherein an extended portion of the color filter (CFE) of the third subpixel (SP3) is disposed to overlap with the non-opening bank portion (NBA) of the fourth subpixel (SP4), and
wherein the extended portion of the color filter (CFE) of the third subpixel (SP3) overlaps with or does not overlap with the color filter (CF4) of the fourth subpixel (SP4).

14. The light emitting display apparatus of any one of the preceding claims, wherein the common electrode (CE) further includes a low-reflection metal layer and/or the pixel electrode (AE) further includes a low-reflection metal layer.

15. The light emitting display apparatus of any one of the preceding claims, further comprising a transmittance control film disposed on a rear surface of the substrate (111), preferably the transmittance control film includes at least one of a transparent film and a light absorbing film.
